# EUROPEAN PATENT APPLICATION

(11) **EP 2 509 304 A1**
(43) Date of publication of application: **10.10.2012**
(21) Application number: 10834382.3
(22) Date of filing: 02.12.2010
(51) Int. Cl.: H04N 5/64, G09F 9/00, H05K 7/20

(54) **RADIATION UNIT OF ELECTRONIC DEVICE AND ELECTRONIC DEVICE USING SAME**

(30) Priority: 03.12.2009 JP 2009275130; 07.12.2009 JP 2009277296; 12.01.2010 JP 2010003765; 18.03.2010 JP 2010062359; 24.03.2010 JP 2010067617; 12.05.2010 JP 2010109805; 14.05.2010 JP 2010111725; 06.09.2010 JP 2010198470; 30.09.2010 JP 2010221144
(71) Applicant: Panasonic Corporation, Kadoma-shi Osaka 571-8501 (JP)
(72) Inventor: MURAYAMA, Takuya, Chuo-ku Osaka 540-6207 (JP); WAKAMATSU, Tomonori, Chuo-Ku Osaka 540-6207 (JP); SUGIYAMA, Makoto, Chuo-Ku Osaka 540-6207 (JP); KATSUMI, Yoshimasa, Chuo-ku Osaka 540-6207 (JP); MIYAKE, Shunji, Chuo-Ku Osaka 540-6207 (JP)
(74) Representative: Grünecker, Kinkeldey, Stockmair & Schwanhäusser
(86) International application number: PCT/JP2010/007020
(87) International publication number: WO 2011/067929

(57) **Abstract**

A cooling unit for electronic devices includes a partition board, a heat exchanger, and a blower. The partition board is disposed on one of a plurality of surfaces of an electronic device so as to partition the inner and the outer side of the electronic device. The heat exchanger is disposed on the outer side so as to exchange heat generated by the electronic device with outside air. The blower is disposed on the outer side. The partition board has a first vent and a second vent. The heat exchanger includes hot-air passage bodies and air pathways. The hot-air passage bodies include a plurality of air passages arranged side by side at predetermined intervals in such a manner as to connect the first vent and the second vent on the outer side. The air pathways are formed between adjacent ones of the air passages so as to allow the outside air to pass through the air pathways. The blower blows air of the inner side from the first vent to the second vent through the hot-air passage bodies.

## Description

### TECHNICAL FIELD

The present invention relates to a cooling unit for electronic devices, and an electronic device including the cooling unit.

### BACKGROUND OF THE INVENTION

Electronic devices such as television receivers have a display unit on the front side of the body case, and the control unit of the display unit inside the body case. The back surface of the control unit is closed by a partition board. These electronic devices are often suspended from the ceiling (see, for example, Patent Literature 1).

Television receivers have been equipped with increasingly large display units in recent years, and there have been efforts to install them outdoors as advertising devices by making good use of their visual effects.

Television receivers used outdoors need to be configured to protect the body case from rain infiltration. For this purpose, the front and back openings of the body case are sealed by the display unit and the partition board, respectively.

This sealing structure, however, cannot provide sufficient heat radiation behind the display unit and inside the control unit in the body case. The conventional television receivers solve this problem by providing a metal partition board behind the body case, a plurality of metal fins both inside and outside the partition board, and a blower for stirring the air in the body case.

The blower stirs the air in the body case so as to conduct the heat inside the body case to the fins inside the body case, and to the fins outside the body case via the partition board, thereby radiating the heat outside.

As well known, however, a plurality of metal fins disposed both inside and outside a metal partition board are very heavy, causing television receivers to be too heavy to be installed at high points outdoors.

### Citation List

### Patent Literature

Patent Literature 1: Japanese Patent Unexamined Publication No. H07-322172

### SUMMARY OF THE INVENTION

The present invention is directed to provide a cooling unit for electronic devices. The cooling unit includes a partition board, a heat exchanger, and a blower. The partition board is disposed on one of a plurality of surfaces of an electronic device so as to partition the inner and the outer side of the electronic device. The heat exchanger is disposed on the outer side so as to exchange heat generated by the electronic device with outside air. The blower is disposed on the outer side. The partition board has a first vent and a second vent. The heat exchanger includes hot-air passage bodies and air pathways. The hot-air passage bodies include a plurality of air passages arranged side by side at predetermined intervals in such a manner as to connect the first vent and the second vent on the outer side. The air pathways are formed between adjacent ones of the air passages so as to allow the outside air to pass through. The blower blows air of the inner side from the first vent to the second vent through the hot-air passage bodies.

With this structure, the blower blows the heat generated in the electronic device to the heat exchanger outside the electronic device, thereby effectively radiating the heat. The heat exchanger is formed of lightweight hot-air passage bodies, allowing both the cooling unit and the electronic device including the cooling unit to be lightweight.

### BRIEF DESCRIPTION OF DRAWINGS

Fig. 1 is a perspective view of an example of installation of an electronic device according to a first exemplary embodiment of the present invention.
Fig. 2 is a rear perspective view of the electronic device according to the first exemplary embodiment.
Fig. 3 is an exploded rear perspective view of the electronic device according to the first exemplary embodiment.
Fig. 4 is a rear perspective view of a cooling unit of the electronic device according to the first exemplary embodiment.
Fig. 5A is a front view of a cooling unit of the electronic device according to the first exemplary embodiment.
Fig. 5B is a top view of a cooling unit of the electronic device according to the first exemplary embodiment.
Fig. 5C is a side view of a cooling unit of the electronic device according to the first exemplary embodiment.
Fig. 5D is a bottom view of a cooling unit of the electronic device according to the first exemplary embodiment.
Fig. 6A is a vertical sectional view of air pathways of a cooling unit of the electronic device according to the first exemplary embodiment.
Fig. 6B is a vertical sectional view of air passages of a cooling unit of the electronic device according to the first exemplary embodiment.
Fig. 7A is a perspective view of the electronic device according to the first exemplary embodiment when the body case of the electronic device is placed in landscape orientation.
Fig. 7B is a perspective view of the electronic device according to the first exemplary embodiment when the body case is placed in portrait orientation.
Fig. 8 is a rear perspective view of a cooling unit of an electronic device according to a second exemplary embodiment of the present invention.
Fig. 9A is a front view of a cooling unit of the electronic device according to the second exemplary embodiment.
Fig. 9B is a top view of a cooling unit of the electronic device according to the second exemplary embodiment.
Fig. 9C is a side view of a cooling unit of the electronic device according to the second exemplary embodiment.
Fig. 9D is a bottom view of a cooling unit of the electronic device according to the second exemplary embodiment.
Fig. 10 is a rear perspective view of a cooling unit of an electronic device according to a third exemplary embodiment of the present invention.
Fig. 11A is a front view of a cooling unit of the electronic device according to the third exemplary embodiment.
Fig. 11B is a top view of a cooling unit of the electronic device according to the third exemplary embodiment.
Fig. 11C is a side view of a cooling unit of the electronic device according to the third exemplary embodiment.
Fig. 11D is a bottom view of a cooling unit of the electronic device according to the third exemplary embodiment.
Fig. 12 shows an example of installation of an electronic device according to a fourth exemplary embodiment of the present invention.
Fig. 13 is a rear view of the electronic device according to the fourth exemplary embodiment.
Fig. 14A is a sectional side view of airflow through convection passages in the electronic device according to the fourth exemplary embodiment.
Fig. 14B is a sectional side view of airflow through radiation air passages in the electronic device according to the fourth exemplary embodiment.
Fig. 15 is a configuration of the cooling unit of the electronic device according to the fourth exemplary embodiment.
Fig. 16 is a rear view of the cooling unit of the electronic device according to the fourth exemplary embodiment, which is installed in the electronic device.
Fig. 17A is an overview of the heat exchangers of the cooling unit of the electronic device according to the fourth exemplary embodiment.
Fig. 17B is a view taken along line 17B-17B of Fig. 17A.
Fig. 18 shows the electronic device according to the fourth exemplary embodiment in which a partition board is in contact with thermal conductive members.
Fig. 19A is an overview of the heat exchangers of the cooling unit of an electronic device according to a fifth exemplary embodiment of the present invention.
Fig. 19B is a view taken along line 19B-19B of Fig. 19A.
Fig. 19C is a view taken along line 19C-19C of Fig. 19A.
Fig. 20A is an overview of the heat exchangers of the cooling unit of the electronic device according to the fifth exemplary embodiment.
Fig. 20B is a view taken along line 20B-20B of Fig. 20A.
Fig. 21A is a rear view of the cooling unit of an electronic device according to a sixth exemplary embodiment of the present invention when the cooling unit is installed in landscape orientation in the electronic device.
Fig. 21B is a rear view of the cooling unit of the electronic device when the cooling unit is installed in portrait orientation in the electronic device.
Fig. 22 is an overview of a metal heatsink used the heat exchangers of the cooling unit of an electronic device according to a seventh exemplary embodiment of the present invention.
Fig. 23A shows the heat exchangers of the cooling unit of an electronic device according to an eighth exemplary embodiment of the present invention when the heat exchangers are attached to a partition board.
Fig. 23B is a configuration of the heat exchangers of the cooling unit of the electronic device according to the eighth exemplary embodiment.
Fig. 24 is an exploded rear perspective view of an electronic device according to a ninth exemplary embodiment of the present invention.
Fig. 25A is an exploded rear perspective view of a cooling unit of the electronic device according to the ninth exemplary embodiment.
Fig. 25B is an exploded front perspective view of a cooling unit of the electronic device according to the ninth exemplary embodiment.
Fig. 26A is a vertical sectional view of an outside-air passing area in a cooling unit of the electronic device according to the ninth exemplary embodiment.
Fig. 26B is a vertical sectional view of a hot-air passing area in a cooling unit of the electronic device according to the ninth exemplary embodiment.
Fig. 27A is a perspective view of the electronic device according to the ninth exemplary embodiment when the body case of the electronic device is placed in landscape orientation.
Fig. 27B is a perspective view of the electronic device according to the ninth exemplary embodiment when the body case is placed in portrait orientation.
Fig. 28 is an exploded rear perspective view of an electronic device according to a tenth exemplary embodiment of the present invention.
Fig. 29A is a vertical sectional view of an outside-air passing area in a cooling unit of the electronic device according to the tenth exemplary embodiment.
Fig. 29B is a vertical sectional view of a hot-air passing area in a cooling unit of the electronic device according to the tenth exemplary embodiment.
Fig. 30A is an exploded rear perspective view of a cooling unit of the electronic device according to the tenth exemplary embodiment of the present invention.
Fig. 30B is an exploded front perspective view of a cooling unit of the electronic device according to the tenth exemplary embodiment of the present invention.
Fig. 31 is a perspective view of the cooling unit of the electronic device according to the tenth exemplary embodiment of the present invention.
Fig. 32 is a rear view of an electronic device according to an eleventh exemplary embodiment of the present invention.
Fig. 33A is a vertical sectional view of an outside-air passing area in a cooling unit of the electronic device according to the eleventh exemplary embodiment.
Fig. 33B is a vertical sectional view of a hot-air passing area in a cooling unit of the electronic device according to the eleventh exemplary embodiment.
Fig. 34 is an exploded perspective view of the cooling units of the electronic device according to the eleventh exemplary embodiment.
Fig. 35A is an overview of the heat exchangers of the cooling units of the electronic device according to the eleventh exemplary embodiment.
Fig. 35B is a view taken along line 35B-35B of Fig. 35A.
Fig. 35C is a view taken along line 35C-35C of Fig. 35A.
Fig. 36 shows the electronic device according to the eleventh exemplary embodiment in which the partition board of the cooling units is in contact with high-heating parts.
Fig. 37 is an exploded perspective view of the cooling units of another electronic device according to the eleventh exemplary embodiment.
Fig. 38A is an overview of the heat exchangers of the cooling units of an electronic device according to a twelfth exemplary embodiment of the present invention.
Fig. 38B is a view taken along line 38B-38B of Fig. 38A.
Fig. 38C is a view taken along line 38C-38C of Fig. 38A.
Fig. 39 is an exploded perspective view of the cooling units of an electronic device according to a thirteenth exemplary embodiment of the present invention.
Fig. 40 is a sectional side view of the cooling units of the electronic device according to the thirteenth exemplary embodiment.
Fig. 41A is a rear view of a display panel of an electronic device according to a fourteenth exemplary embodiment of the present invention when the display panel is placed in landscape orientation.
Fig. 41B is a rear view of the display panel of the electronic device according to the fourteenth exemplary embodiment when the display panel is placed in portrait orientation.
Fig. 42 is a perspective view of a cooling unit of an electronic device according to a fifteenth exemplary embodiment of the present invention.
Fig. 43 is an exploded perspective view of a cooling unit of the electronic device according to the fifteenth exemplary embodiment.
Fig. 44 is an enlarged exploded perspective view of a cooling unit of the electronic device according to the fifteenth exemplary embodiment.
Fig. 45 is a rear perspective view of an electronic device according to a sixteenth exemplary embodiment of the present invention.
Fig. 46 is an exploded rear perspective view of the electronic device according to the sixteenth exemplary embodiment.
Fig. 47A is a perspective view of a part of a cooling unit of the electronic device according to the sixteenth exemplary embodiment.
Fig. 47B is a sectional view of a cooling unit of the electronic device according to the sixteenth exemplary embodiment.
Fig. 48A is a perspective view of a heat exchanger and a partition board of a cooling unit of the electronic device according to the sixteenth exemplary embodiment.
Fig. 48B is a front view of a heat exchanger and a partition board of a cooling unit of the electronic device according to the sixteenth exemplary embodiment.
Fig. 49 is a view taken along line 49A-49A of Fig. 47B.
Fig. 50 is a view taken along line 50C-50C of Fig. 47B.
Fig. 51 is a sectional view of the electronic device according to the sixteenth exemplary embodiment.
Fig. 52 is an enlarged view of part "E" of Fig. 51.
Fig. 53 is an enlarged view of part "F" of Fig. 51.
Fig. 54 is a view taken along line 54G-54G of Fig. 52.
Fig. 55 is a view to be compared with the shape of the air passageways of Fig. 49.
Fig. 56 is a view to be compared with the shape of the air passageways of Fig. 50.
Fig. 57 is a view to be compared with the enlarged view of Fig. 52 showing a blower air inlet and its vicinity.
Fig. 58 is a sectional view of a cooling unit of an electronic device according to a seventeenth exemplary embodiment of the present invention.
Fig. 59 is a view taken along line 59H-59H of Fig. 58.
Fig. 60 is a view to be compared with the shape of the air passageways of Fig. 59.
Fig. 61 is a perspective view of the air passages of the heat exchanger of a cooling unit of an electronic device according to an eighteenth exemplary embodiment of the present invention.
Fig. 62A is a front view of the heat exchanger of a cooling unit of the electronic device according to the eighteenth exemplary embodiment.
Fig. 62B is a side view of the heat exchanger of a cooling unit of the electronic device according to the eighteenth exemplary embodiment.
Fig. 63 is an exploded perspective view of the heat exchanger of a cooling unit of the electronic device according to the eighteenth exemplary embodiment.
Fig. 64A is a sectional side view of the electronic device according to the eighteenth exemplary embodiment and air passages in the electronic device.
Fig. 64B is a sectional side view showing air passages outside the heat exchanger of a cooling unit of the electronic device according to the eighteenth exemplary embodiment.

### DESCRIPTION OF EMBODIMENTS

Embodiments of the present invention will be described as follows with reference to accompanying drawings.

### FIRST EXEMPLARY EMBODIMENT

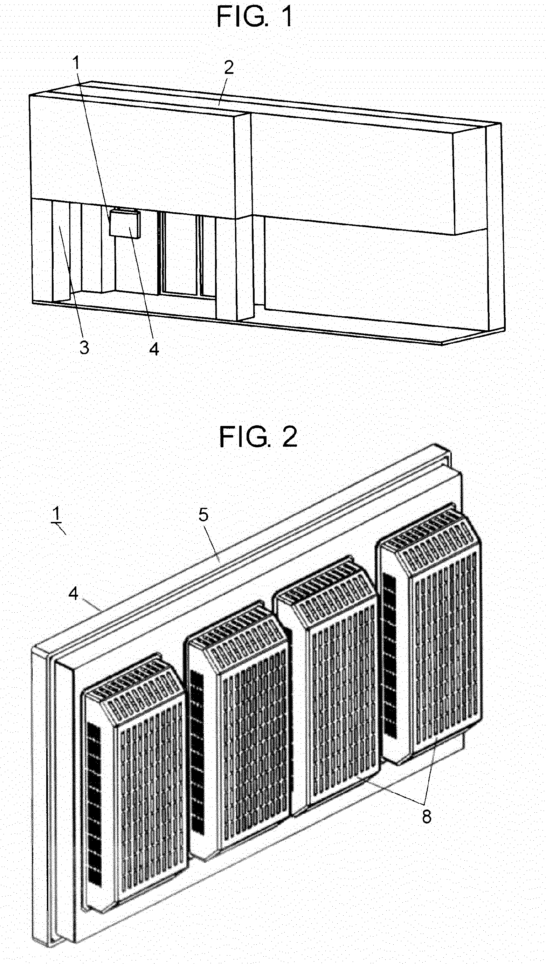

Fig. 1 is a perspective view of an example of installation of an electronic device according to a first exemplary embodiment of the present invention. Display device 1, which is an example of the electronic device, can be used to display advertisement outdoors in addition to functioning as a television receiver.

In Fig. 1, display device 1 is installed outdoors, namely, under the eaves 3 of shop 2. Display device 1 has display unit 4 on its front side. Display unit 4 has a horizontally long rectangular shape (a quadrate). As mentioned above, the "front" is the side on which display unit 4 is disposed in display device 1, and the "back" is the side which is opposite to display unit 4 in display device 1.

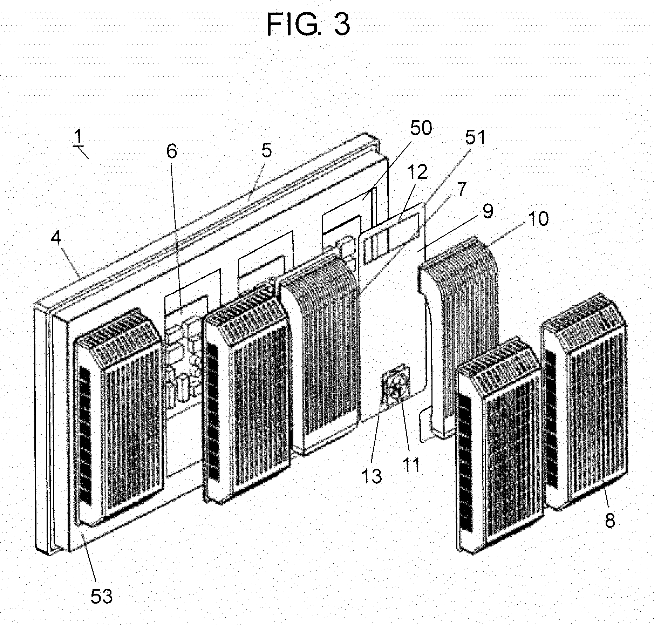

Fig. 2 is a rear perspective view of the electronic device according to the first exemplary embodiment, and Fig. 3 is an exploded rear perspective view of the electronic device. As shown in Figs. 2 and 3, display device 1, which has a plurality of surfaces, includes body case 5, display unit 4, control units 6, cooling units 7, and rear covers 8. Body case 5 is open on both front and back sides, which have a horizontally long rectangular shape. Display unit 4 is disposed in such a manner that the front opening of body case 5 is sealed watertight. Control units 6 for controlling display unit 4 are disposed behind the display unit 4 in body case 5. Cooling units 7 are disposed in such a manner as to watertight seal the back openings of body case 5 separately. Rear covers 8 cover the outer surfaces of cooling units 7 while allowing air through.

In the first exemplary embodiment, as shown in Fig. 3, four cooling units 7 are arranged from side to side in such a manner as to watertight seal the back openings of body case 5.

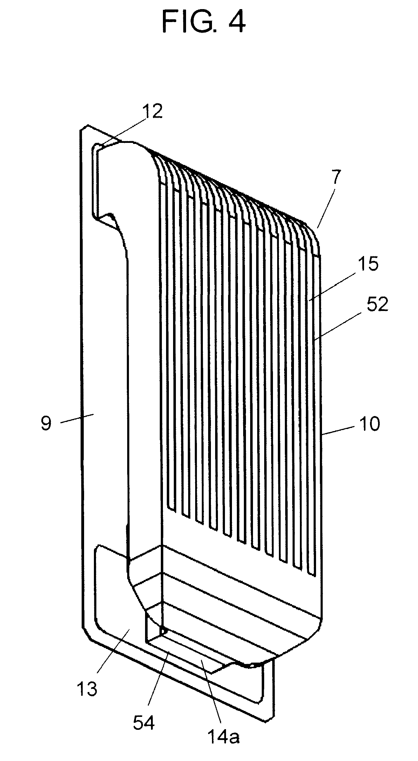

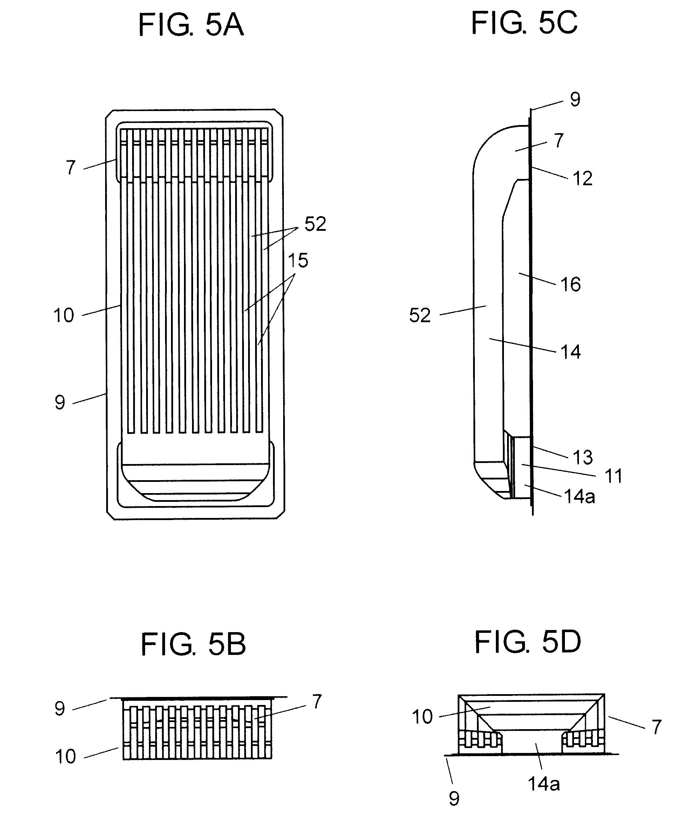

Fig. 4 is a rear perspective view of a cooling unit of the electronic device according to the first exemplary embodiment. Figs. 5A, 5B, 5C, and 5D are front, top, side, and bottom views, respectively, of a cooling unit of the electronic device. As shown in Fig. 4 and Figs. 5A through 5D, each of four cooling units 7 includes partition board 9, heat exchanger 10, and blower 11. Partition boards 9 are metallic and have a vertically long rectangular shape. Partition boards 9 are attached to the back openings of body case 5 of display device 1 as shown in Fig. 3 so as to partition the inside and outside of body case 5 watertight. More specifically, partition boards 9 are attached to one surface 53 of display device 1 so as to partition inner side 50 and outer side 51 of display device 1 as shown in Fig. 3.

Heat exchangers 10 are disposed on outer side 51 of partition boards 9 so as to exchange the heat from display device 1 with the outside air.

Blowers 11 are disposed on outer side 51 of partition boards 9, that is, outside body case 5.

Partition boards 9 of four cooling units 7 have a vertically long rectangular shape in the present first exemplary embodiment, but may alternatively have a horizontally long rectangular shape or a square shape depending on the shape of body case 5 or other factors. If four cooling units 7 are integrated into a single unit, there is provided a single partition board 9 having a horizontally long rectangular shape.

Each of the four partition boards 9 has upper vent 12 as a first vent along its upper edge and lower vent 13 as a second vent along its lower edge as shown in Figs. 3 and 4. Thus, display device 1 includes four partition boards 9 on one surface 53 thereof.

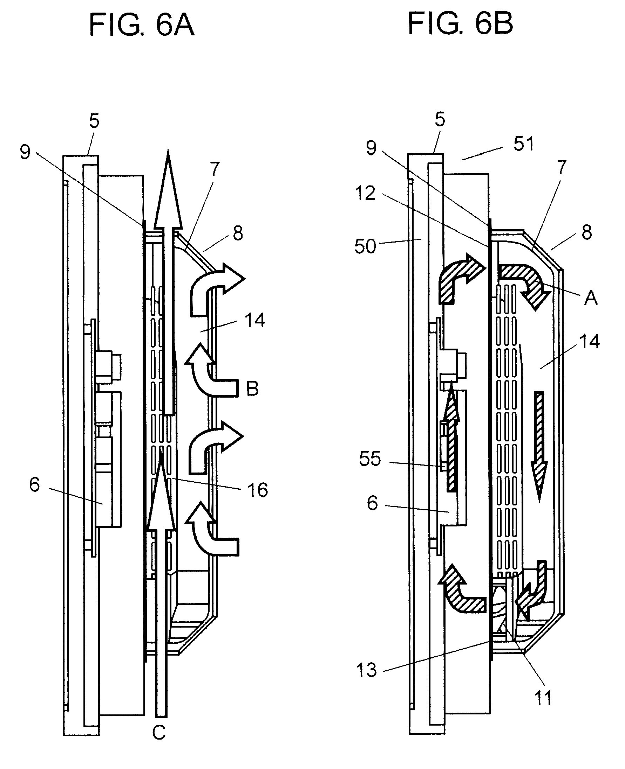

Figs. 6A and 6B are vertical sectional views of air pathways and air passages, respectively, of a cooling unit of the electronic device according to the first exemplary embodiment. As shown in Figs. 4, 6A, and 6B, each heat exchanger 10 includes hot-air passage bodies 14 and air pathways 15 on outer side 51. Hot-air passage bodies 14 consist of vertically long air passages 52 which are arranged side by side at intervals and extend like bridges to connect upper vent 12 and lower vent 13. Air pathways 15 are formed between adjacent ones of air passages 52 so as to allow the outside air to pass therethrough. Hot-air passage bodies 14 are made of synthetic resin and cylindrically shaped. Each blower 11 blows the air on inner side 50 from upper vent 12 to lower vent 13 through hot-air passage bodies 14.

In each heat exchanger 10, air passages 52 are combined into one on the upper vent 12 side and connected to upper vent 12, and are also combined into one on the lower vent 13 side and connected to lower vent 13. Blower 11 is disposed at lower collecting duct 14a in which air passages 52 are connected to lower vent 13. In the present first exemplary embodiment, each blower 11 is previously attached to lower vent 13 of partition board 9, and is covered with lower collecting duct 14a of hot-air passage bodies 14. Thus, air passages 52 are connected to lower vent 13 via lower collecting duct 14a.

As shown in Fig. 5C, hot-air passage bodies 14 include convection paths 16 between partition board 9 and air passages 52. Convection paths 16 extend between the bottom of upper vent 12 and the top of lower vent 13. Each rear cover 8 shown in Figs. 6A and 6B has a large number of holes to allow air through vertically and horizontally.

Thus, display unit 4 and partition boards 9 seal the front and back openings, respectively, of body case 5 watertight. This causes the heat from display unit 4 and control units 6 to be trapped in body case 5.

This is the reason the above-described cooling units 7 are provided in the present first exemplary embodiment. When blowers 11 are driven, as shown by the arrows "A" of Fig. 6B, the heat in body case 5 is exhausted as hot air through upper vents 12 into hot-air passage bodies 14, that is, to the outside of body case 5.

The hot air in body case 5 flows along hot-air passage bodies 14 down to lower vents 13 so as to be cooled, and is then again blown into body case 5 by blowers 11.

In this case, as shown by the arrows "B" in Fig. 6A, the outside air coming in through rear covers 8, which allow air through vertically and horizontally, flows up along the outer surfaces of hot-air passage bodies 14. The hot air "A" flowing down through hot-air passage bodies 14 is cooled by the heat exchange with the outside air "B" and "C". As shown in Fig. 6B, each blower 11 blows the cooled air against hot part 55 of control unit 6 through lower vent 13, thereby effectively cooling control unit 6.

In the present first exemplary embodiment, hot-air passage bodies 14 are made of synthetic resin having lower thermal conductivity than metals, but are thin enough to allow heat exchange.

As shown in Fig. 6A, hot-air passage bodies 14 of the present first exemplary embodiment include convection paths 16 outside partition boards 9. Therefore, the outside air coming in through rear covers 8 flows up also along convection paths 16 as shown by the arrow "C", thereby being heat exchanged with the hot air inside hot-air passage bodies 14.

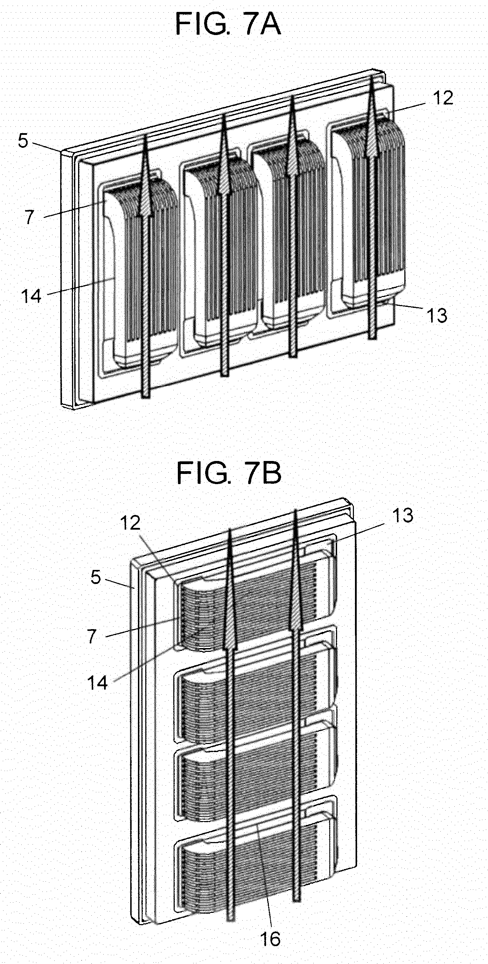

Figs. 7A and 7B are perspective views of the electronic device according to the first exemplary embodiment when the body case of the electronic device is placed in landscape and portrait orientation, respectively. To provide better visual effects, horizontally long body case 5, which is longer in the horizontal direction than in the vertical direction, may be placed in portrait orientation, that is, longer in the vertical direction than in the horizontal direction as shown in Fig. 7B.

When body case 5 has a horizontally long rectangular shape as shown in Fig. 7A, upper vents 12 are formed in positions corresponding to the upper region of body case 5, and lower vents 13 are formed in positions corresponding to the lower region of body case 5. When body case 5 has a vertically long rectangular shape as shown in Fig. 7B, upper vents 12 are formed in positions corresponding to one of the left and right sides of body case 5, and lower vents 13 are formed in positions corresponding to the other side of body case 5.

When horizontally long body case 5 is placed in portrait orientation, the outside air flows up straight through convection paths 16 of hot-air passage bodies 14. This fully allows heat exchange between the outside air and the hot air inside hot-air passage bodies 14.

As described hereinbefore, in the present first exemplary embodiment, the heat that is generated by display unit 4 and control units 6 and is then trapped in body case 5 is exhausted by cooling units 7 to the outside of body case 5, thereby being effectively cooled by the outside air.

Hot-air passage bodies 14 of cooling units 7 are disposed only outside body case 5, thereby easily preventing an increase in the weight of the electronic device. More specifically, unlike conventional electronic devices, display device 1 of the present first exemplary embodiment does not need to be provided with radiating fins inside. Blowers 11 blow the heat in display device 1 into heat exchangers 10 disposed outside display device 1, thereby effectively radiating the heat. As a result, an electronic device including cooling units 7 can be lightweight.

In the present first exemplary embodiment, blowers 11 are disposed on outer side 51 of partition boards 9. As a result, partition boards 9 have a flat surface on inner side 50, allowing control units 6 to be designed and laid out very flexibly.

Blowers 11 are configured to blow cooled air into body case 5 from lower vents 13. This prevents an increase in blast resistance, allowing a large amount of cooled air to be blown into control units 6, thereby having high cooling effect.

Hot parts 55 in control units 6 are disposed in the vicinity of lower vents 13 and therefore can be directly subjected to the cooled air that comes in through lower vents 13. This further improves the effect of cooling control units 6.

Blowers 11, which allow only cooled air to pass through them, are not subjected to overheating and therefore have long life.

### SECOND EXEMPLARY EMBODIMENT

In a second exemplary embodiment of the present invention, the same components as in the first exemplary embodiment are denoted by the same reference numerals, and hence the description thereof will be omitted. The following description will be focused on the differences.

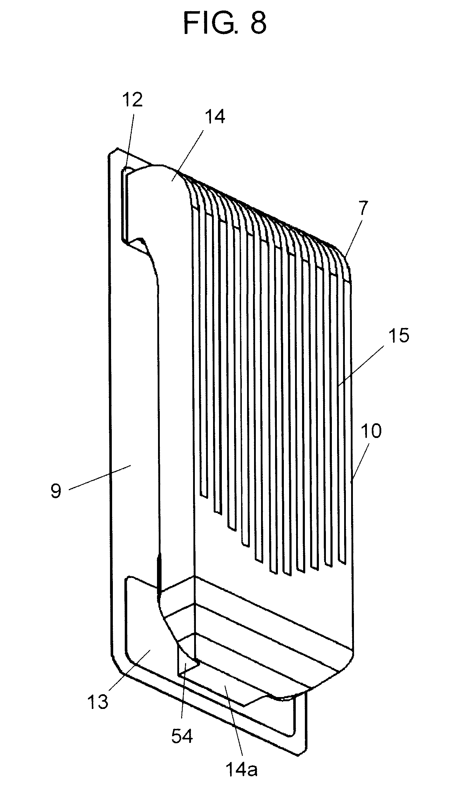

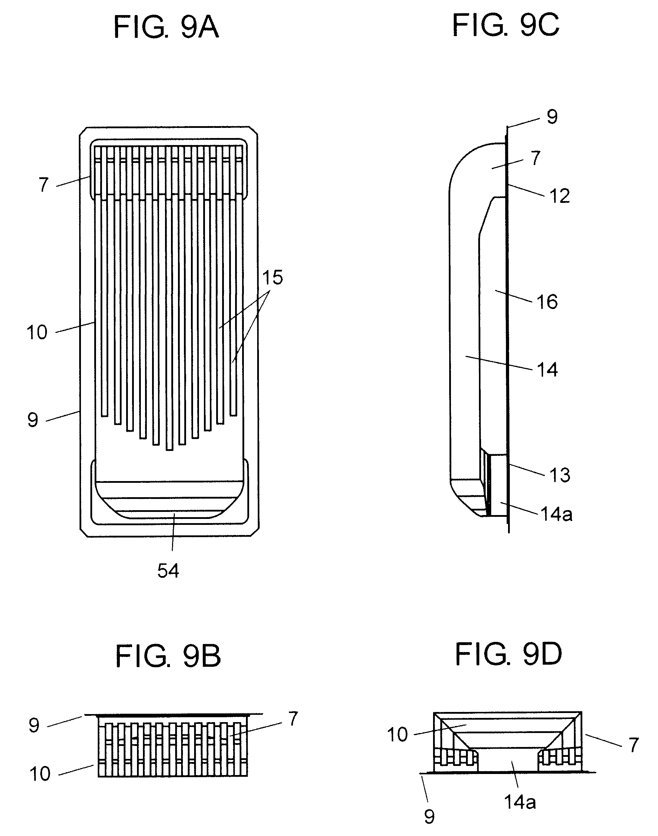

Fig. 8 is a rear perspective view of a cooling unit of an electronic device according to the second exemplary embodiment. Figs. 9A, 9B, 9C, and 9D are front, top, side, and bottom views, respectively, of a cooling unit of the electronic device.

As shown in Fig. 8 and Figs. 9A through 9D, in each heat exchanger 10, air pathways 15 formed along hot-air passage bodies 14 decrease in length with distance from the center of connection surface 54.

As a result, all air pathways 15 have the same length between upper vent 12 and lower vent 13, thereby equalizing the amount of air flowing through all hot-air passage bodies 14. This increases the heat exchange efficiency of the entire heat exchanger 10.

### THIRD EXEMPLARY EMBODIMENT

In a third exemplary embodiment of the present invention, the same components as in the first exemplary embodiment are denoted by the same reference numerals, and hence the description thereof will be omitted. The following description will be focused on the differences.

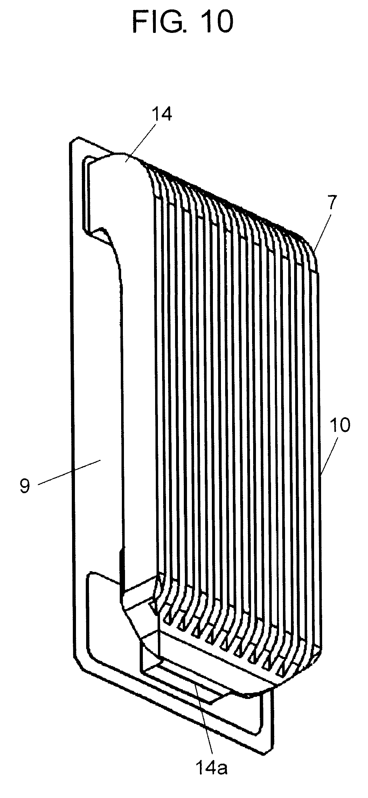

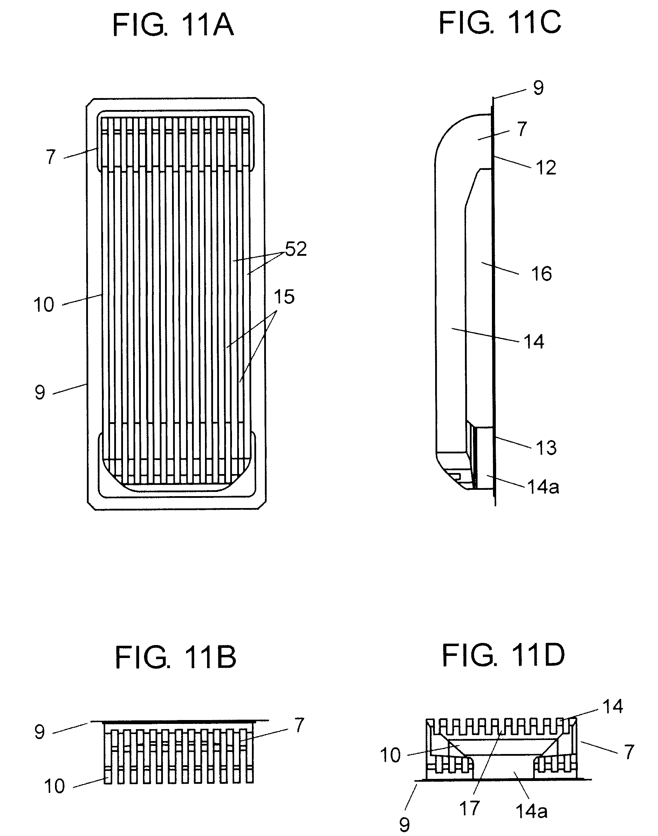

Fig. 10 is a rear perspective view of a cooling unit of an electronic device according to the third exemplary embodiment. Figs. 11A, 11B, 11C, and 11D are front, top, side, and bottom views, respectively, of a cooling unit of the electronic device.

As shown in Fig. 10 and Figs. 11A through 11D, in each heat exchanger 10, air passages 52 of hot-air passage bodies 14 are combined into one in lower collecting duct 14a. Lower collecting duct 14a is provided with projections and recesses, which correspond to the shape of air passages 52 of hot-air passage bodies 14 and the shape of air pathways 15, respectively. When a cooling unit 7 is seen in the cross section orthogonal to the direction in which the air flows through hot-air passage bodies 14, air passages 52 are in the form of projections, and air pathways 15 are in the form of recesses behind display device 1. These projections and recesses coincide with the projections and recesses of lower collecting duct 14a. Thus, lower collecting duct 14a is provided with airflow grooves 17, which are communicated with air pathways 15.

With this structure, the shape of air passages 52 facilitates the flow of the hot air from upper vents 12 to lower vents 13. Furthermore, in lower collecting ducts 14a, airflow grooves 17 increase the efficiency of exhausting the heat of the hot air flowing through air passages 52. Airflow grooves 17 also function to guide the upwardly flowing outside air smoothly to air pathways 15. This allows efficient heat exchange between the outside air flowing through airflow grooves 17 and air pathways 15, and the hot air flowing through air passages 52.

### FOURTH EXEMPLARY EMBODIMENT

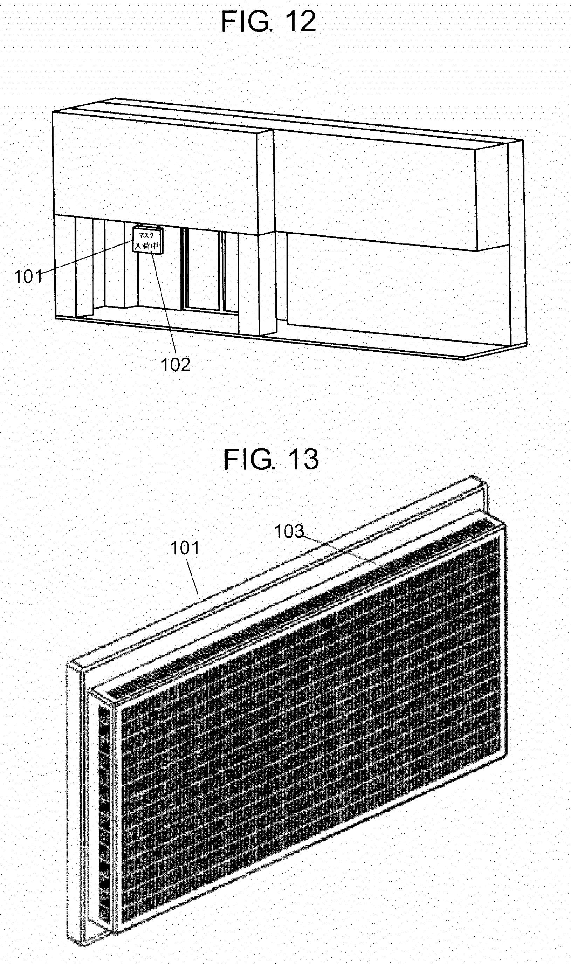

Fig. 12 shows an example of installation of an electronic device according to a fourth exemplary embodiment of the present invention. In Fig. 12, display device 101, which is an example of the electronic device, is hung at the entrance of a drugstore. Display device 101 has display unit 102, which provides customers with a message containing real-time information. The message may be, for example, about the availability of an item that has been long awaited by customers, such as "Masks are now in stock!"

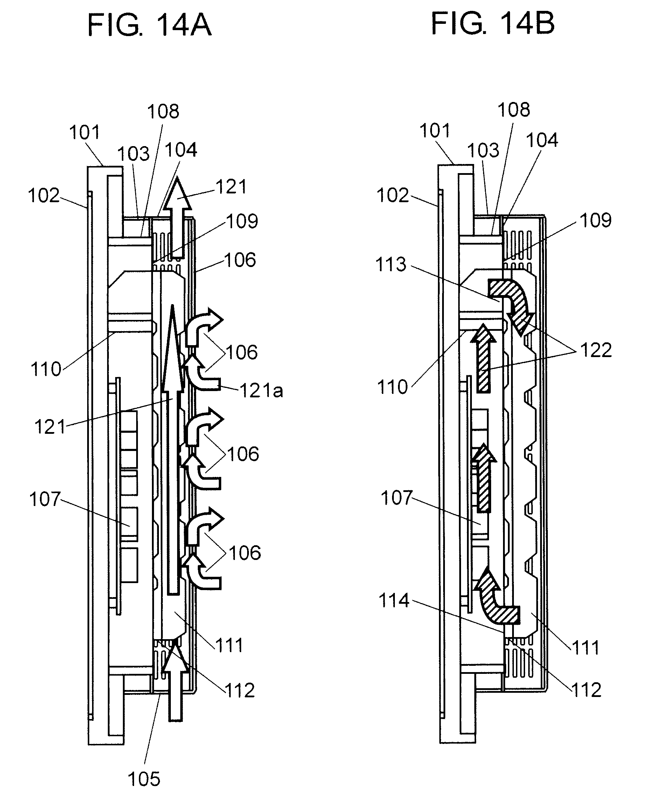

Fig. 13 is a rear view of the electronic device. Figs. 14A and 14B are sectional side views of airflow through convection passages and through radiation air passages, respectively, in the electronic device. As shown in Fig. 13, display device 101 has, on its back side, rear cover 103 containing a large number of holes. As shown in Fig. 14A, rear cover 103 has first openings 104, second openings 105, and third openings 106 on its upper, lower, and back sides, respectively.

As described above, display device 101 includes display unit 102, which is an electronic display device such as a plasma display panel. As shown in Fig. 14A, display device 101 includes control units 107, which control display unit 102 to display images. Each control unit 107 is covered with cover 108. Behind covers 108, there is provided partition board 109, which covers the back openings of control units 107.

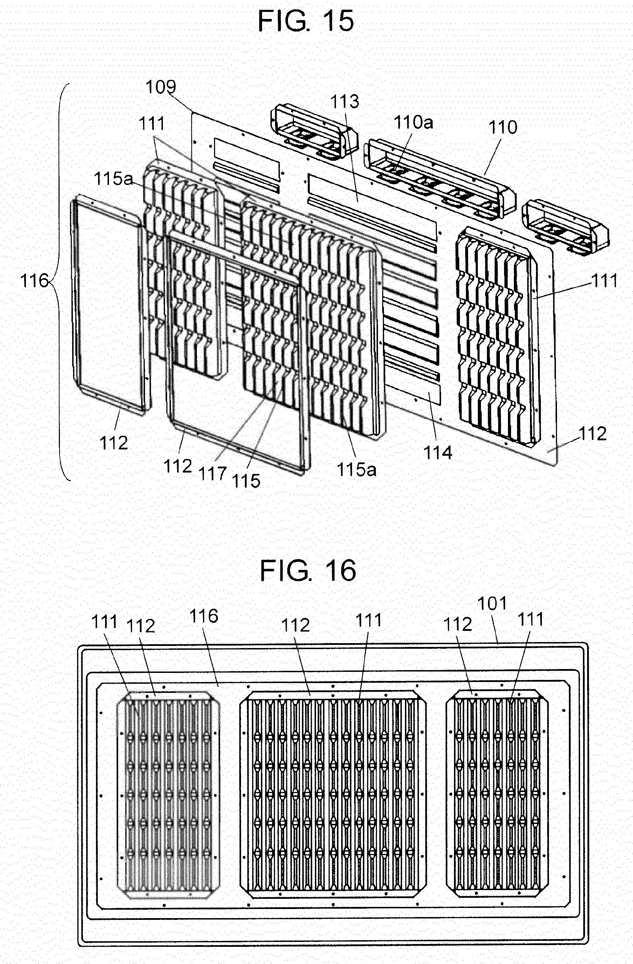

Fig. 15 is a configuration of the cooling unit of the electronic device according to the fourth exemplary embodiment. As shown in Fig. 15, the cooling unit includes blowers 110 inside partition board 109 and heat exchangers 111 outside partition board 109. Heat exchangers 111 are integrally pressure-welded to partition board 109 by frame bodies 112. Covers 108 and partition board 109 are covered with rear cover 103 from behind display device 101.

Partition board 109 is provided with upper vents 113 and lower vents 114, which are horizontally long and parallel with the upper edge and the lower edge, respectively. Thus, upper and lower vents 113 and 114 formed in the upper and lower regions, respectively, of partition board 109 are horizontally long holes.

As shown in Figs. 14A and 14B, upper vents 113 as first vents and lower vent 114 as second vents are opposed to peaks 115a of heat exchangers 111. As shown in Figs. 14A and 14B, blowers 110 are disposed in the vicinity of upper vents 113 on the other side of partition board 109.

As shown in Fig. 15, blowers 110 are disposed over control units 107 and inside covers 108. The exhaust ports of blowers 110 are connected to upper vents 113 of partition board 109, so that blowers 110 can blow air into heat exchangers 111 through these openings of partition board 109.

Blowers 110, partition board 109, heat exchangers 111, and frame bodies 112 together form cooling unit 116.

Thus, control units 107 of display device 101 are open on the back side, and these openings are closed by partition board 109 of cooling unit 116.

Fig. 16 is a rear view of the cooling unit of the electronic device according to the fourth exemplary embodiment, which is installed in the electronic device. As shown in Figs. 14A, 14B, 15, and 16, cooling unit 116 is integrated with the back side of control units 107. In horizontally long display device 101, control units 107 are arranged as three different blocks, and exchangers 111 of cooling unit 116 are disposed in these blocks.

Each blower 110 includes a plurality of fans 110a arranged horizontally.

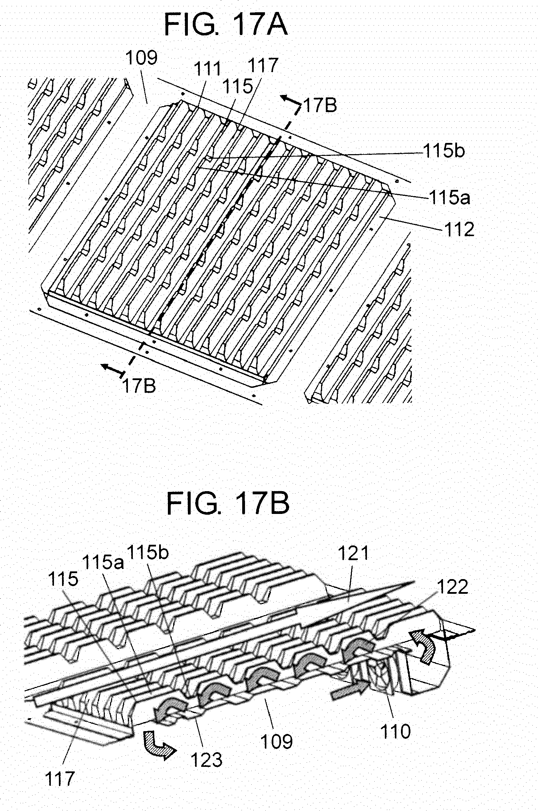

Fig. 17A is an overview of the heat exchangers of the cooling unit of the electronic device according to the fourth exemplary embodiment, and Fig. 17B is a view taken along line 17B-17B of Fig. 17A. As shown in Fig. 17A, heat exchangers 111 are boards made of synthetic resin such as polystyrene. Each heat exchanger 111 is formed of peaks and valleys 115, and valley-forming parts 117, which are disposed alternately in the horizontal direction. Peaks and valleys 115 consist of peaks 115a and valleys 115b alternating in the vertical direction outside display device 101. Valley-forming parts 117 consist of successive valleys.

As shown in Fig. 17B, peaks and valleys 115 and valley-forming parts 117 together form air passageways on the front and back sides of heat exchangers 111. The air passageways are in the shape of vertically long grooves. On the back side of peaks and valleys 115, there are formed radiation air passages 122. On the front side of valley-forming parts 117, there are formed convection passages 121.

As shown in Fig. 14B, radiation air passages 122 are vertical passages along grooves formed by peaks and valleys 115 arranged inside heat exchangers 111. These passages change their direction to be horizontal at upper vents 113 and lower vents 114 of partition board 109, thereby forming a U shape.

As shown in Fig. 17B, the portions of partition board 109 that are opposite to valleys 115b of peaks and valleys 115 are swollen toward the inside of display device 101. The swollen portions make peaks 115a and valleys 115b alternately meander to form radiation air passages 122. Partition board 109 is provided with swollen bands 123, which are swollen toward the inside of display device 101 in such a manner as to correspond to valleys 115b of peaks and valleys 115.

Convection passages 121 are vertical passages along valley-forming parts 117, and are communicated with the outside air via first, second, and third openings 104, 105, 106 in rear cover 103.

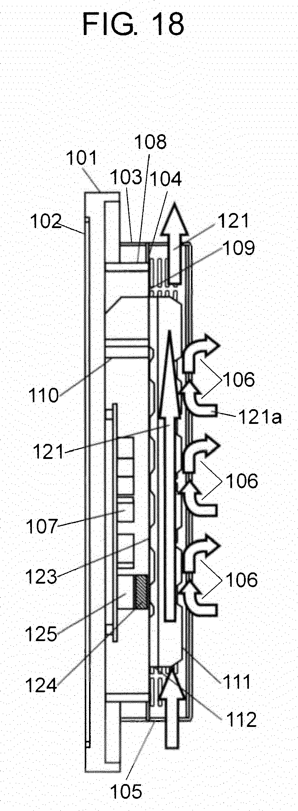

Fig. 18 shows the electronic device according to the fourth exemplary embodiment in which the partition board is in contact with thermal conductive members. As shown in Fig. 18, partition board 109 is brought into contact with heating parts 125 of display device 101 with thermal conductive members 124 disposed therebetween. Particularly when partition board 109 is made of a material with high thermal conductivity such as metal, the heat of heating parts 125 is conducted to partition board 109 directly via thermal conductive members 124, and then to heat exchangers 111. Thus, the heat of heating parts 125 is efficiently radiated.

When display device 101 is driven, display unit 102 is turned on to display the availability of an item that has been long awaited by customers. At this moment, however, circuit components in control units 107 produce high heat.

Compared with TVs used indoors, display device 101, which is intended for people walking outdoors, needs to have display unit 102 with high luminance. As a result, display device 101 requires a large electric power and produces high heat. Since display device 101 is used outdoors, control units 107 are shielded from dust and rain by covers 108 and cooling unit 116. Thus, the inside of display device 101 is sealed, and consequently, an extremely large amount of heat is trapped there.

To cope with this situation, as soon as display unit 102 is turned on, blowers 110 are started. Inside covers 108, the air above control units 107 is drawn into heat exchangers 111 through upper vents 113, and is then returned into display device 101 through lower vents 114.

Blowers 110 forcibly circulate the air present inside covers 108 through radiation air passages 122 such that the heat generated by control units 107 is conducted to heat exchangers 111.

This results in an increase in the temperature inside heat exchangers 111, that is, inside peaks and valleys 115. As a result, a temperature gradient is established between the inside of peaks and valleys 115 and the outside of display device 101 by the synthetic resin boards. The temperature gradient creates air natural convection inside rear cover 103. The natural convection allows the air to flow through valley-forming parts 117 of heat exchangers 111 and then to flow upward through first and third openings 104 and 106 toward the outside air region, thereby becoming an ascending air current. As a result, outside air comes in through second openings 105 so as to accelerate the natural convection, thereby providing high heat radiation effect. The temperature rise in heat exchangers 111 creates micro convections 121a between convection passages 121 of heat exchangers 111 and the outside air at third openings 106. Micro convections 121a are local convections as shown in Fig. 14A. The air flowing in and out due to micro convections 121a accelerates the heat radiation effect in heat exchangers 111, that is, in display device 101.

Heat exchangers 111 are lightweight because they are synthetic resin boards, more particularly, polystyrene resin boards. Heat exchangers 111 made of polystyrene resin are much lighterweight especially than heatsinks, which are currently employed as radiating parts and are mainly composed of aluminum.

Heat exchangers 111 can be integrally molded to ensure the airtightness between the inside and outside of display device 101 with ease.

### FIFTH EXEMPLARY EMBODIMENT

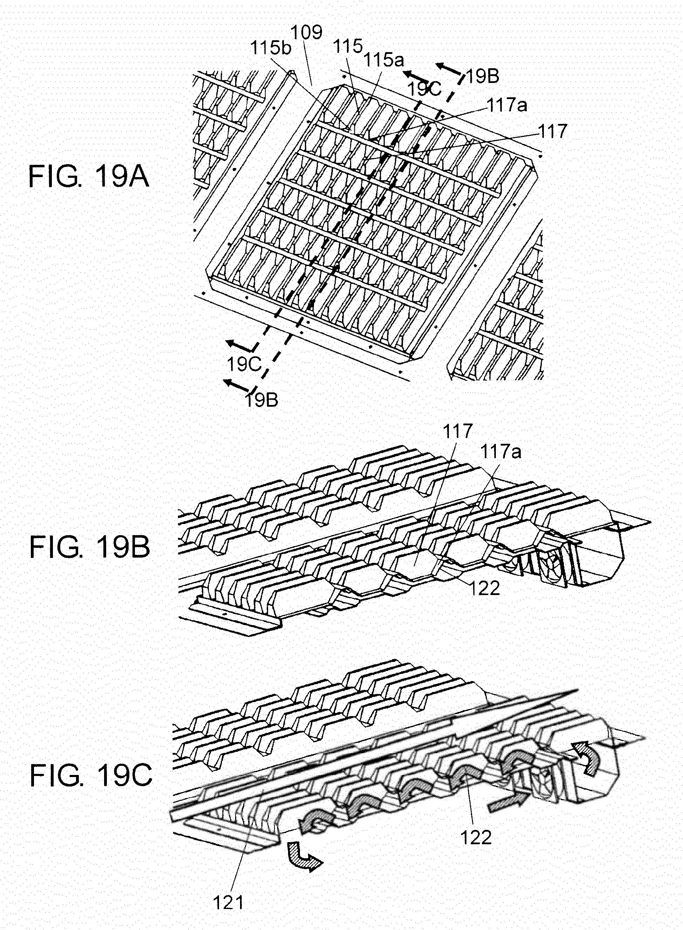

In a fifth exemplary embodiment, the same components as in the fourth exemplary embodiment are denoted by the same reference numerals, and hence the description thereof will be omitted. The following description will be focused on the differences. Fig. 19A is an overview of the heat exchangers of the cooling unit of an electronic device according to the fifth exemplary embodiment. Fig. 19B is a view taken along line 19B-19B of Fig. 19A. Fig. 19C is a view taken along line 19C-19C of Fig. 19A.

As shown in Fig. 19A, valley-forming parts 117 adjacent to valleys 115b of peaks and valleys 115 are provided with projections 117a, which are of the same height as valleys 115b. Projections 117a of valley-forming parts 117 generate air-passage-enlarged parts between the inner side of valley-forming parts 117 and partition board 109. This allows more of the air that is flowing through radiation air passages 122 to flow into air-passage-enlarged parts. Thus, projections 117a reduce the airflow resistance of valley-forming parts 117 and increase the amount of air flowing through valley-forming parts 117. Valley-forming parts 117 have a large surface area on the outer side, thereby radiating a large amount of heat from the inside of display device 101 to the outside.

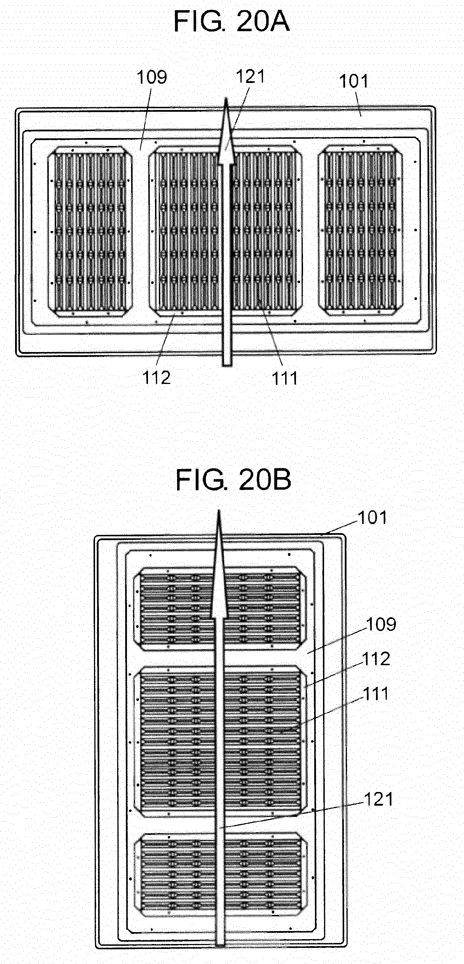

Fig. 20A is an overview of the heat exchangers of the cooling unit of the electronic device according to the fifth exemplary embodiment. Fig. 20B is a view taken along line 20B-20B of Fig. 20A.

When display device 101 is placed in landscape orientation as shown in Fig. 20A, the outside air flows through convection passages 121 between adjacent ones of valley-forming parts 117, thereby radiating the heat from display device 101. When display device 101 is placed in portrait orientation as shown in Fig. 20B, the outside air flows through valleys 115b of peaks and valleys 115 shown in Fig. 19A. Since projections 117a and valleys 115b have the same height, the air can smoothly flow upward, thereby providing high heat radiation effect.

### SIXTH EXEMPLARY EMBODIMENT

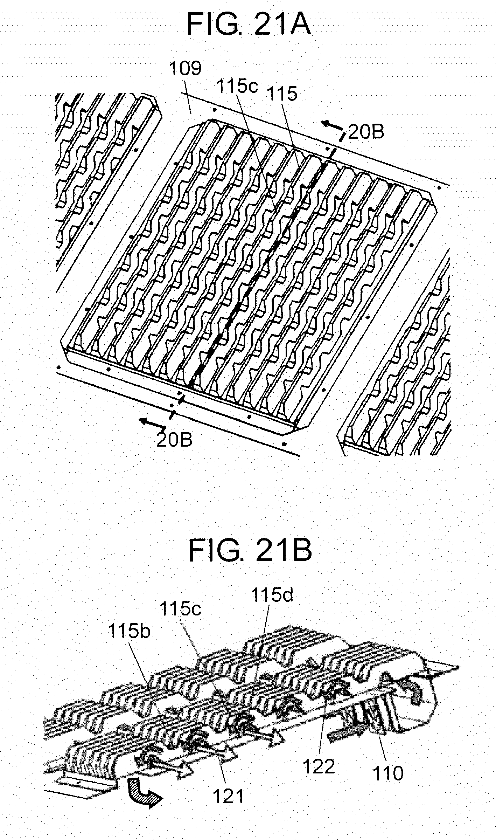

In a sixth exemplary embodiment, the same components as in the fourth exemplary embodiment are denoted by the same reference numerals, and hence the description thereof will be omitted. The following description will be focused on the differences. Figs. 21A and 21B are rear views of the cooling unit of an electronic device according to the sixth exemplary embodiment when the cooling unit is installed in the landscape and portrait orientation, respectively, in the electronic device.

In the present sixth exemplary embodiment, heat exchangers 111 are configured to operate more efficiently. Peaks 115a of peaks and valleys 115 provided in the fourth exemplary embodiment are replaced by peaks 115c in the present sixth exemplary embodiment as shown in Fig. 21A.

As shown in Fig. 21B, peaks 115c are provided with tunnel parts 115d through their centers. Tunnel parts 115d allow the outside air to pass through them outside heat exchangers 111. Radiation air passages 122 are more meandered inside heat exchangers 111.

In radiation air passages 122, the air flowing through peaks 115c and valleys 115b is largely meandered by tunnel parts 115d of peaks 115c. In convection passages 121, the air flows along valley-forming parts 117 and then flows upward while being repeatedly mixed with the air passing through adjacent valley-forming parts 117 in tunnel parts 115d. This increases the heat transfer area, thereby radiating heat from display device 101 more effectively.

The heat radiation effect is especially large when display device 101 is placed in portrait orientation as shown in Fig. 20B because the outside air passes through tunnel parts 115d.

### SEVENTH EXEMPLARY EMBODIMENT

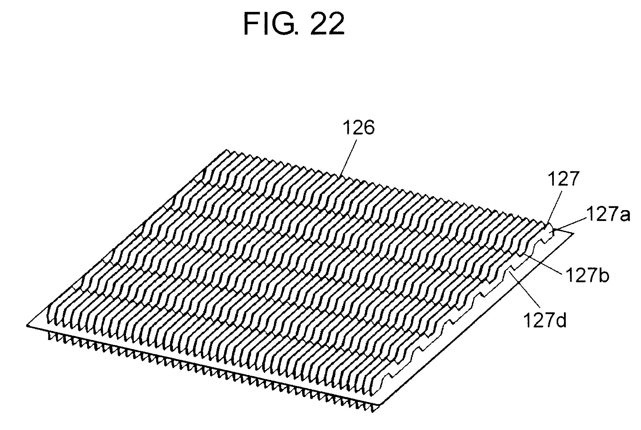

In a seventh exemplary embodiment, the same components as in the fourth exemplary embodiment are denoted by the same reference numerals, and hence the description thereof will be omitted. The following description will be focused on the differences. Fig. 22 is an overview of a metal heatsink used for the heat exchangers of the cooling unit of an electronic device according to the seventh exemplary embodiment. As shown in Fig. 22, metal heatsink 126 is provided with peaks and valleys 127 consisting of alternating peaks 127a and valleys 127b, and is further provided with tunnel parts 127d going through peaks 127a. Heatsink 126 is disposed on the back side of display device 101 so that sufficient heat radiation effect can be obtained whether display device 101 is placed in landscape or portrait orientation.

### EIGHTH EXEMPLARY EMBODIMENT

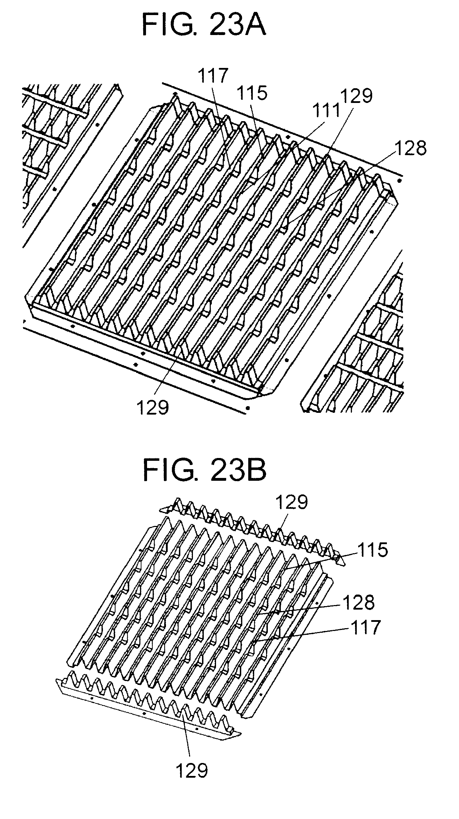

An eighth exemplary embodiment will describe another example of heat exchangers 111. In the eighth exemplary embodiment, the same components as in the fourth exemplary embodiment are denoted by the same reference numerals, and hence the description thereof will be omitted. The following description will be focused on the differences. Fig. 23A shows the heat exchangers of the cooling unit of an electronic device according to the eighth exemplary embodiment when the heat exchangers are attached to a partition board. Fig. 23B is a configuration of the heat exchangers.

As shown in Figs. 23A and 23B, each heat exchanger 111 has main part 128 and end face parts 129. Main part 128 is formed of peaks and valleys 115, and valley-forming parts 117, which are disposed alternatingly. End face parts 129 seal the end faces of peaks and valleys 115 and the end faces of valley-forming parts 117. Thus, end face parts 129 cover the end faces of main part 128 from outside.

In each heat exchanger 111, main part 128 and end face parts 129 covering it are integrally welded.

As a result, the length of main parts 128 in heat exchangers 111 can be easily adjusted to the shape of display device 101.

### NINTH EXEMPLARY EMBODIMENT

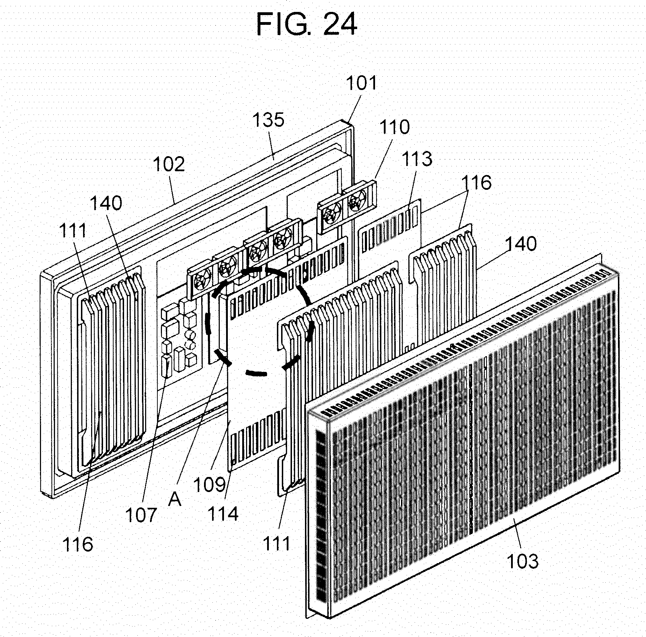

In a ninth exemplary embodiment, the same components as in the fourth exemplary embodiment are denoted by the same reference numerals, and hence the description thereof will be omitted. The following description will be focused on the differences. Fig. 24 is an exploded rear perspective view of an electronic device according to the ninth exemplary embodiment.

As shown in Fig. 24, display device 101 includes body case 135, display unit 102, control units 107, cooling units 116, and rear cover 103. Body case 135 is horizontally long and is open on both front and back sides. Display unit 102 is disposed in such a manner as to watertight seal the front opening of body case 135. Control units 107 for controlling display unit 102 are disposed in body case 135. Cooling units 116 are disposed in such a manner as to watertight seal the back openings of body case 135. Rear cover 103 covers the back side of cooling units 116 while allowing air through. In the present ninth exemplary embodiment, as shown in Fig. 24, three cooling units 116 are arranged from side to side in such a manner as to watertight seal the back openings of body case 135.

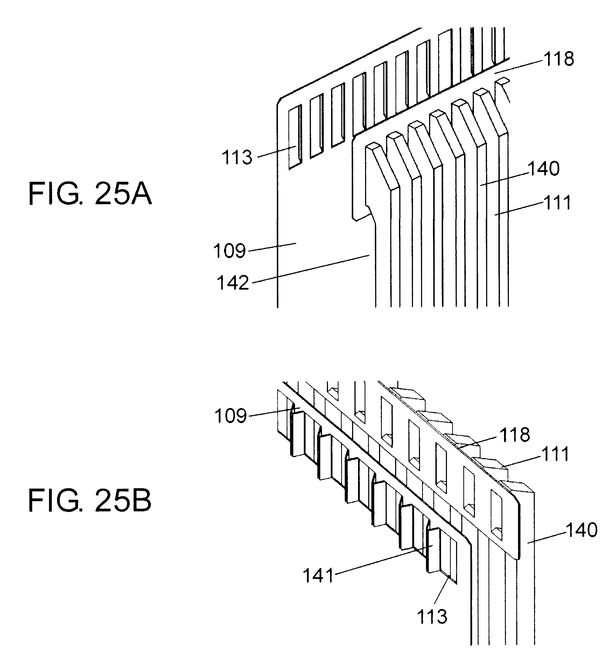

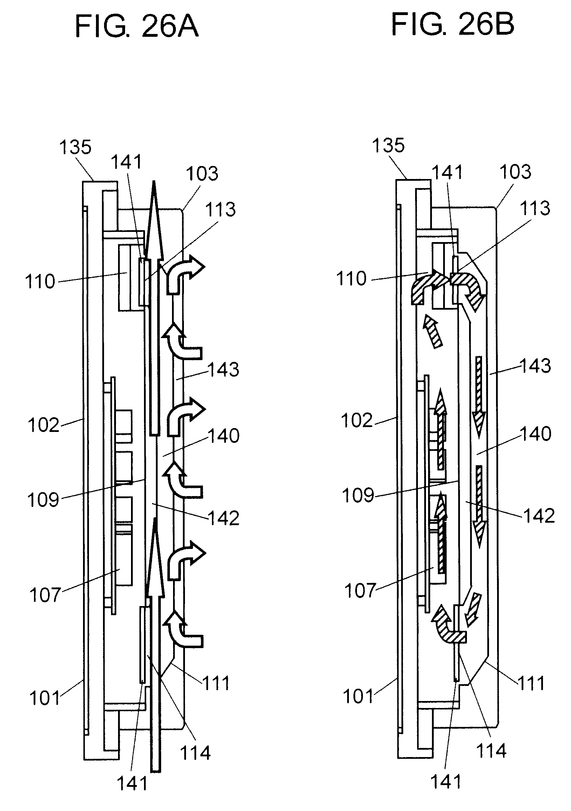

Fig. 25A is an exploded rear perspective view of a cooling unit of the electronic device according to the ninth exemplary embodiment. Fig. 25B is an exploded front perspective view of a cooling unit of the electronic device. Fig. 26A is a vertical sectional view of an outside-air passing area in a cooling unit of the electronic device. Fig. 26B is a vertical sectional view of a hot-air passing area in a cooling unit of the electronic device.

Three cooling units 116 are disposed over the back openings of body case 135 of display device 101 as shown in Figs. 25A, 25B, 26A, and 26B. Each cooling unit 116 includes partition board 109, heat exchanger 111, and blower 110. Partition boards 109 are metallic and have a vertically long shape so as to partition the inside and outside of body case 135 watertight. Heat exchangers 111 are disposed on the outer side of partition boards 109, that is, outside body case 135. Blowers 110 are disposed on the inner side of partition boards 109, that is, inside body case 135. Partition boards 109 have a vertically long rectangular shape in the present ninth exemplary embodiment, but may alternatively have a horizontally long rectangular shape or a square shape depending on the shape of body case 135 or other factors. If three cooling units 116 are integrated into a single cooling unit 116, there is provided a single partition board 109 having a horizontally long rectangular shape.

As shown in Figs. 24, 25A, and 25B, each partition board 109 has a plurality of upper vents 113 and a plurality of lower vents 114, which are arranged in the horizontal direction. Upper vents 113 are predeterminedly spaced from each other at the top of partition board 109, and lower vents 114 are predeterminedly spaced from each other at the bottom of partition board 109.

Each heat exchanger 111 includes vertically long hot-air passage bodies 140, which vertically extend like bridges to connect upper vents 113 and lower vents 114 on the outer side of partition board 109, that is, outside body case 135.

Thus, hot-air passage bodies 140, which are made of synthetic resin and cylindrically shaped, connect upper vents 113 and lower vents 114 in the outside of body case 135.

As shown in Figs. 26A and 26B, each blower 110 blows the air present in body case 135 through upper vents 113 of partition board 109 to hot-air passage bodies 140, and then to lower vents 114. Lower vents 114 have a larger opening area than upper vents 113 so that the ventilation resistance can be low.

As shown in Fig. 25B, each partition board 109 includes projecting guide members 141 between adjacent ones of upper vents 113. Guide members 141 are formed at the same time as upper vents 113 by making cuts into the portions of partition board 109 that correspond to upper vents 113 and folding them toward the inside of body case 135 at the vertical center lines of upper vents 113.

Guide members 141 are provided so that blowers 110 can effectively distribute hot air to upper vents 113, which are larger in number than blowers 110.

Projecting guide members 141 are also provided between adjacent ones of lower vents 114 in the same manner as upper vents 113. These guide members 141 are formed at the same time as lower vents 114 by making cuts into the portions of partition board 109 that correspond to lower vents 114 and folding them toward the inside of body case 135 at the vertical center lines of lower vents 114.

Guide members 141 formed between lower vents 114 prevent the air blown out through lower vents 114 from expanding rapidly, thereby preventing an increase in the airflow resistance.

Hot-air passage bodies 140 extend like bridges to connect upper vents 113 and lower vents 114. In each heat exchanger 111, between partition board 109 and hot-air passage bodies 140 there are provided convection paths 142.

Rear cover 103 is breathable in the vertical and horizontal directions. In each heat exchanger 111, between rear cover 103 and hot-air passage bodies 140 there are provided air passageways 143 as shown in Figs. 26A and 26B.

As shown in Figs. 25A and 25B, there are also provided attachment plates 118 at the top and bottom of each partition board 109 in order to integrate the plurality of upper vents 113 and the plurality of lower vents 114. Although not illustrated, attachment plates 118 have openings at their portions corresponding to upper vents 113 and lower vents 114.

The front opening and the back openings of body case 135 are sealed watertight with display unit 102 and with partition boards 109, respectively. Therefore, the heat generated by display unit 102 and control units 107 is trapped in body case 135.

When blowers 110 are driven, as shown in Fig. 26B, the heat in body case 135 is exhausted as hot air through upper vents 113 into hot-air passage bodies 140, that is, to the outside of body case 135.

Later, the air cooled while passing through hot-air passage bodies 140 is drawn into body case 135 through lower vents 114, thereby cooling control units 107.

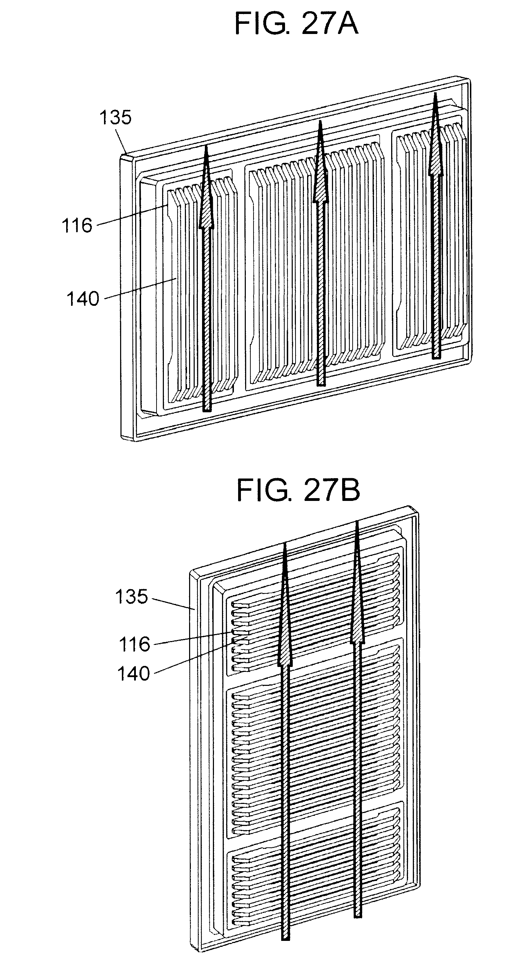

Figs. 27A and 27B are perspective views of the electronic device according to the ninth exemplary embodiment when the body case of the electronic device is placed in landscape and portrait orientation, respectively. The air passing through hot-air passage bodies 140 is cooled by the outside air, which comes in through rear cover 103 and then flows upward along the surfaces of hot-air passage bodies 140 as shown in Figs. 26A and 27A.

In the present ninth exemplary embodiment, hot-air passage bodies 140 are made of synthetic resin having lower thermal conductivity than metals, but are thin enough to have a lower thermal resistance than metals and also to allow heat exchange.

Since hot-air passage bodies 140 in the present ninth exemplary embodiment have convection paths 142 on the side closer to partition boards 109, it may seem that only the air ascending through convection paths 142 is not divided. However, the outside air flows upward by the draft effect due to a temperature increase. Therefore, hot-air passage bodies 140 provide a draft effect of allowing heat exchange between the outside air and the hot air inside hot-air passage bodies 140.

To provide better visual effects of display device 101, horizontally long body case 135 may be placed in portrait orientation as shown in Fig. 27B.

When horizontally long body case 135 is placed in portrait orientation, the outside air flows straight upward through convection paths 142 of hot-air passage bodies 140. This fully allows heat exchange between the outside air and the hot air in hot-air passage bodies 140.

As described above, the heat that is generated by display unit 102 and control units 107 and is then trapped in body case 135 is exhausted by cooling units 116 to the outside of body case 135, thereby effectively being cooled by the outside air.

Hot-air passage bodies 140 of cooling units 116 are disposed only outside body case 135, thereby easily preventing an increase in the weight of the electronic device.

### TENTH EXEMPLARY EMBODIMENT

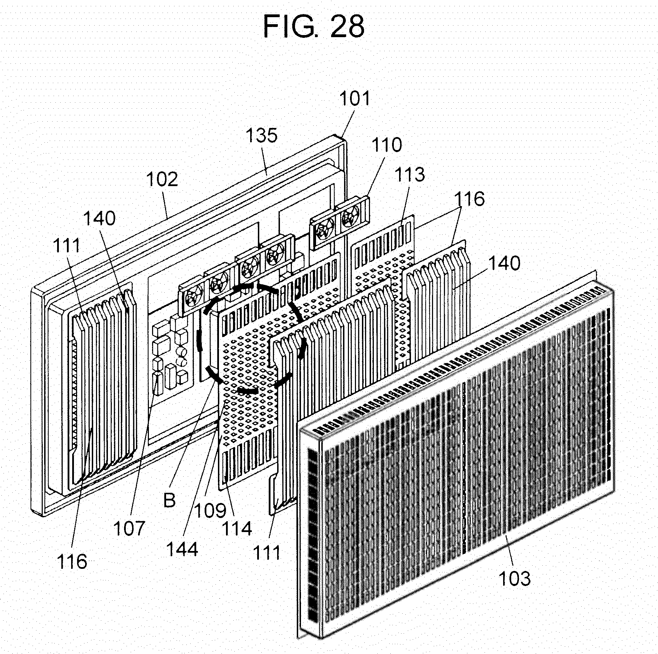

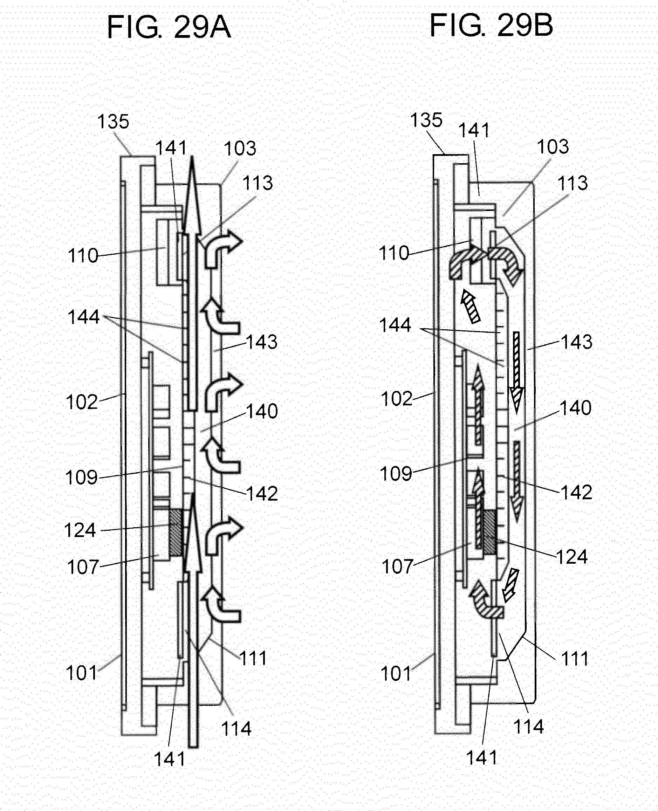

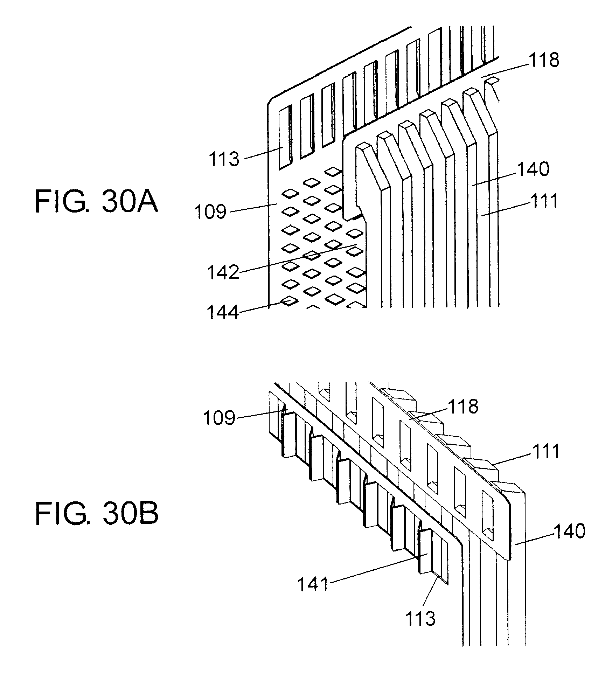

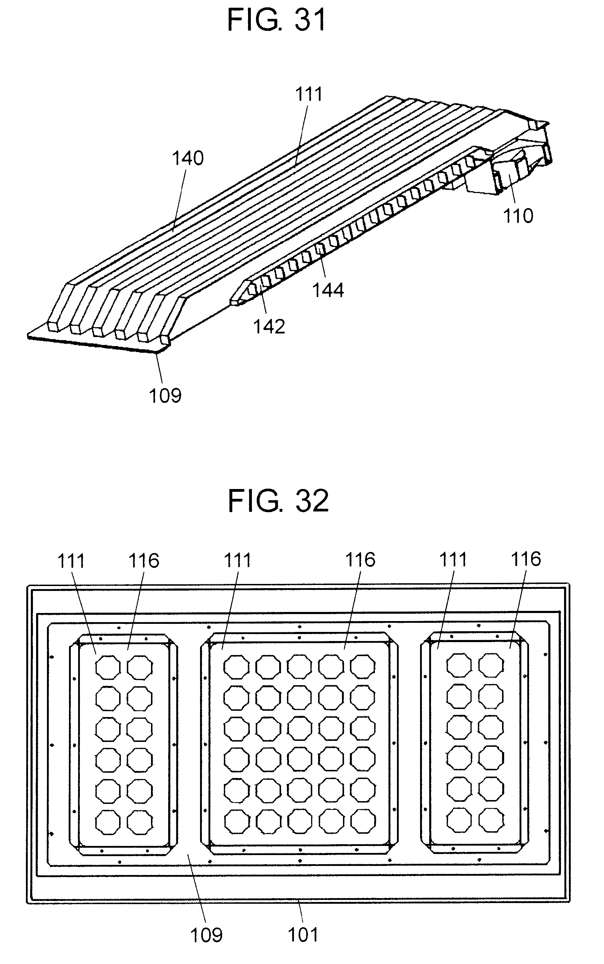

In a tenth exemplary embodiment, the same components as in the fourth and ninth exemplary embodiments are denoted by the same reference numerals, and hence the description thereof will be omitted. The following description will be focused on the differences. Fig. 28 is an exploded rear perspective view of an electronic device according to the tenth exemplary embodiment. Fig. 29A is a vertical sectional view of an outside-air passing area in a cooling unit of the electronic device. Fig. 29B is a vertical sectional view of a hot-air passing area in a cooling unit of the electronic device. Fig. 30A is an exploded rear perspective view of a cooling unit of the electronic device. Fig. 30B is an exploded front perspective view of a cooling unit of the electronic device. Fig. 31 is a perspective view of a cooling unit of the electronic device.

As shown in Figs. 28 through 31, convection paths 142, which are formed between the bottoms of upper vents 113 and the tops of lower vents 114 of partition boards 109, include a plurality of rectifier guides 144. Rectifier guides 144 are arranged at predetermined intervals and substantially at right angles to hot-air passage bodies 140.

When horizontally long body case 135 is placed in portrait orientation as shown in Fig. 27B, rectifier guides 144 facilitate the straight upward movement of the outside air through convection paths 142 of hot-air passage bodies 140.

Metal rectifier guides 144 conduct the heat in body case 135 from metal partition boards 109, thereby providing high heat radiation effect.

In the present tenth exemplary embodiment, as shown in Figs. 29A and 29B, each cooling unit 116 includes thermal conductive member 124, which conducts heat from control unit 107 to metal partition board 109, thereby providing high heat radiation effect.

Hot-air passage bodies 140 made of synthetic resin can be prevented from thermal deformation because they are contact-supported by the tips of some of rectifier guides 144 that are located around the midpoint between upper and lower vents 113 and 114 as shown in Fig. 29B.

The tips of the remaining ones of rectifier guides 144, that is, the tips of those located near upper and lower vents 113 and 114 are out of contact with hot-air passage bodies 140 as shown in Fig. 29B. This prevents the tops and bottoms of hot-air passage bodies 140 from being uplifted from upper and lower vents 113 and 114.

Rectifier guides 144 have a smaller width than in the direction orthogonal to upper and lower vents 113 and 114. If rectifier guides 144 have a large width in the left and right direction between adjacent ones of hot-air passage bodies 140, when body case 135 is placed in landscape orientation, outside air does not have enough power to flow upward through air passageways 143. This is the reason rectifier guides 144 have a smaller width than in the direction orthogonal to upper and lower vents 113 and 114.

### ELEVENTH EXEMPLARY EMBODIMENT

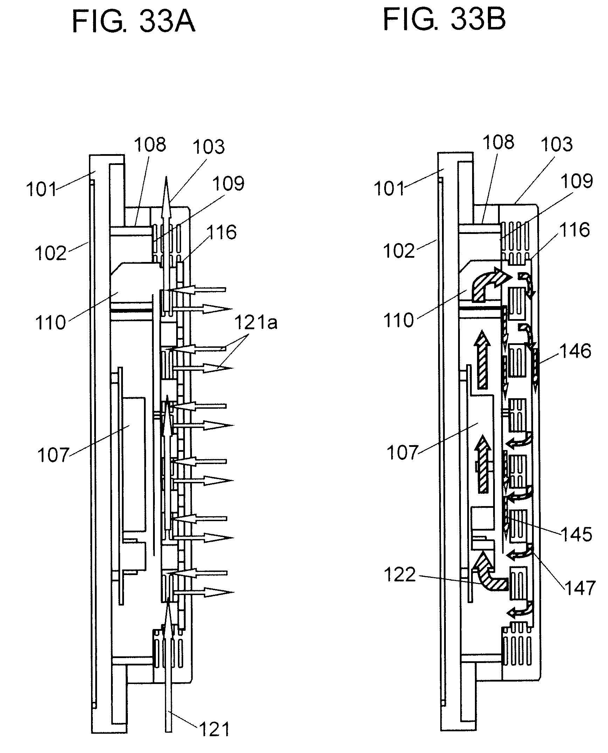

In an eleventh exemplary embodiment, the same components as in the fourth exemplary embodiment are denoted by the same reference numerals, and hence the description thereof will be omitted. The following description will be focused on the differences. Fig. 32 is a rear view of an electronic device according to the eleventh exemplary embodiment. Fig. 33A is a vertical sectional view of an outside-air passing area in a cooling unit of the electronic device according to the eleventh exemplary embodiment. Fig. 33B is a vertical sectional view of a hot-air passing area in a cooling unit of the electronic device.

As shown in Fig. 32, cooling units 116 are disposed inside rear cover 103. Display device 101 includes on its surface, display unit 102, which is an electronic display device such as a plasma display panel. As shown in Fig. 33A, display device 101 includes control units 107, which control display unit 102 to display images. Each control unit 107 is covered with cover 108. Behind covers 108, there is provide partition board 109, which covers the back openings of control units 107.

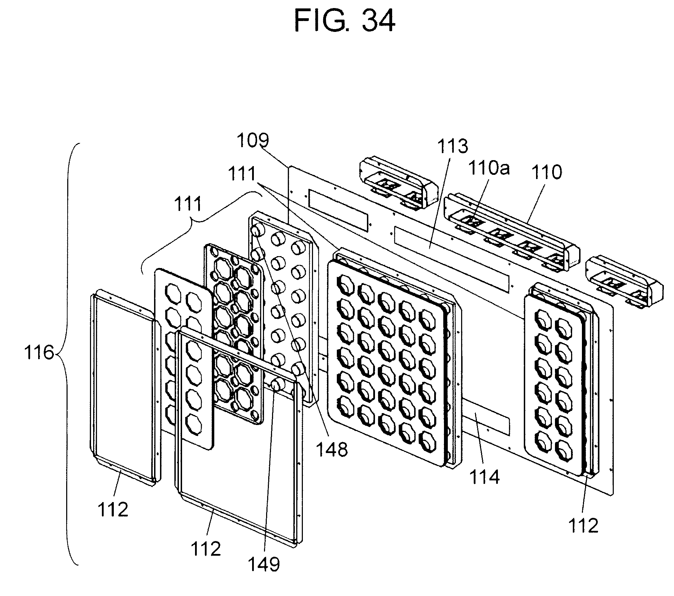

Fig. 34 is an exploded perspective view of the cooling units of the electronic device according to the eleventh exemplary embodiment. Each cooling unit includes blower 110 inside cover 108 and heat exchanger 111 outside cover 108. Heat exchangers 111 are integrally pressure-welded to partition board 109 by frame bodies 112. Covers 108 and frame bodies 112 are covered with rear cover 103 from behind display device 101. Rear cover 103 has a mesh or grid pattern on its top, bottom, and side surfaces, allowing air through vertically and horizontally.

Partition board 109 is provided with upper vents 113 and lower vents 114, which are horizontally long and parallel with the upper edge and the lower edge, respectively. Thus, upper and lower vents 113 and 114 formed in the upper and lower regions, respectively, of partition board 109 are horizontally long holes.

Each heat exchanger 111 includes third air passages 147 each having inlet port 148 and outlet port 149. Inlet ports 148 and outlet ports 149 are opposed to upper vent 113 and lower vent 114, respectively. Each cooling unit 116 further includes blower 110 opposed to lower vent 114 on the side opposite to partition board 109.

Blowers 110 are disposed over control units 107 and inside covers 108. The exhaust ports of blowers 110 are connected to upper vents 113, so that blowers 110 can blow air into inlet ports 148 of third air passages 147 of heat exchangers 111 through these openings of partition board 109.

As shown in Fig. 34, each blower 110 includes a plurality of fans 110a arranged horizontally.

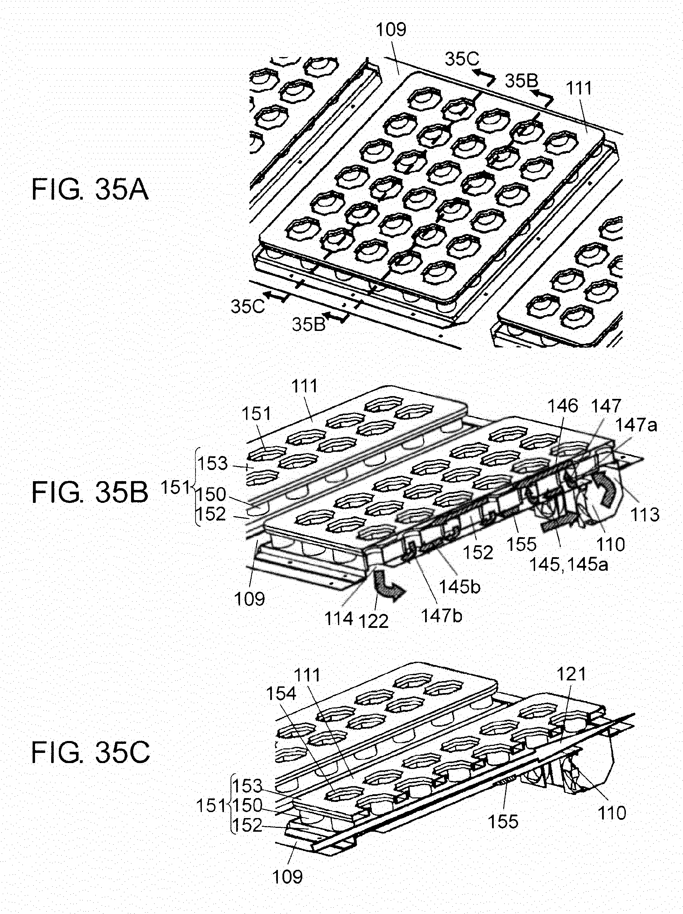

Fig. 35A is an overview of the heat exchangers of the cooling units of the electronic device according to the eleventh exemplary embodiment. Fig. 35B is a view taken along line 35B-35B of Fig. 35A. Fig. 35C is a view taken along line 35C-35C of Fig. 35A. As shown in Fig. 34, each heat exchanger 111 is formed of three board parts made, for example, of polystyrene resin. Each heat exchanger 111 includes radiation air passages 122 shown in Fig. 35B, which are sealed from the outside of display device 101, and convection passages 121 shown in Fig. 35C, which are communicated with the outside. Thus, each heat exchanger 111 is provided with radiation air passages 122 inside and convection passages 121 outside.

Each heat exchanger 111 includes a large number of connection columns 150 and radiation frame 151, in which convection passages 121 are formed. Connection columns 150 project upwardly from base plate 152, which is disposed in parallel with partition board 109. Radiation frame 151 includes base plate 152, connection columns 150, and radiation board member 153, which is connected to the ends of connection columns 150.

Connection columns 150, which have a circular cross section, are arranged in straight rows and columns at predetermined intervals in a grid pattern on base plate 152 and are connected to radiation board member 153.

Radiation board member 153 includes a large number of vent holes 154 arranged in the grid pattern. Vent holes 154 are through-holes formed in radiation board member 153 and arranged in the space between adjacent ones of connection columns 150, that is, the region not containing connection columns 150.

Connection columns 150 and radiation board member 153 are hollow inside, and these hollow portions form a part of radiation air passages 122. Thus, radiation air passages 122 include first air passages 145 between partition board 109 and base plate 152, second air passages 146 inside radiation board member 153, and third air passages 147 inside connection columns 150. As shown in Fig. 33B, each heat exchanger 111 includes radiation air passages 122 inside display device 101.

As shown in Fig. 35B, each heat exchanger 111 is provided with horizontally long shield wall 155, which partitions between upper vent 113 and lower vent 114. Shield wall 155 partitions first air passages 145 into first air passages 145a communicated with upper vent 113, and first air passages 145b communicated with lower vent 114. Shield wall 155 further partitions third air passages 147 into third air passages 147a communicated with first air passages 145a, and third air passages 147b communicated with first air passages 145b. At least the outermost third air passage 147a and at least the outermost third air passage 147b are opposed to upper vent 113 and lower vent 114, respectively. Thus, in each heat exchanger 111, upper vent 113 is opposed to the uppermost inlet port 148, and lower vent 114 is opposed to the lowermost outlet port 149.

As shown in Fig. 33B, in each heat exchanger 111, radiation air passages 122 include first air passages 145 and second air passages 146, which are arranged vertically side by side, and horizontal third air passages 147, which connect first and second air passages 145 and 146. The air coming in and out from each heat exchanger 111 flows horizontally at upper vent 113 and lower vent 114 of partition board 109. Thus, U-shaped air passages are formed inside display device 101.

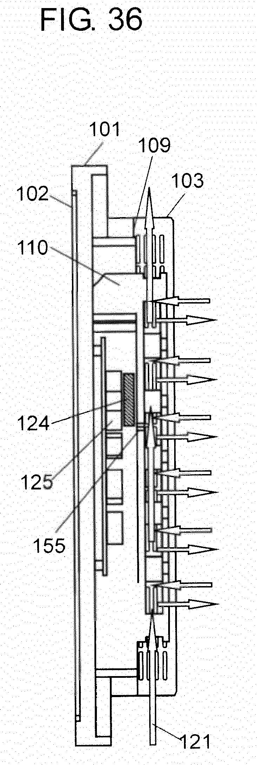

Fig. 36 shows the electronic device according to the eleventh exemplary embodiment in which the partition board of the cooling units is in contact with high-heating parts. Partition board 109 is brought into contact with heating parts 125 such as power semiconductor switching devices via thermal conductive members 124 disposed inside display device 101. Heating parts 125, which are brought into contact with partition board 109 are preferably placed over shield wall 155.

When display device 101 is driven, display unit 102 is turned on to display the availability of an item that has been long awaited by customers. At this moment, however, circuit components in control units 107 produce high heat.

Compared with TVs used indoors, display device 101, which is intended for people walking outdoors, needs to have display unit 102 with high luminance. As a result, display device 101 requires a large electronic power and produces high heat. Since display device 101 is used outdoors, control units 107 are shielded from dust and rain by covers 108 and cooling units 116. Thus, the inside of display device 101 is sealed, and consequently, an extremely large amount of heat is trapped there.

To cope with this situation, as soon as display unit 102 is turned on, blowers 110 are started. Inside covers 108, the air over control units 107 is drawn into heat exchangers 111 through upper vents 113, and is then returned into display device 101 through lower vents 114. The air drawn into heat exchangers 111 flows from first air passages 145a to second air passages 146 via third air passages 147a by the action of shield walls 155, and then flows into radiation board members 153. The air is then flown into first air passages 145b through third air passages 147b, and is blown into display device 101 through lower vents 114.

Since the uppermost third air passage 147a is opposed to upper vent 113, part of the air drawn into heat exchanger 111 by blower 110 is directly blown into inlet port 148 so as to be swiftly flown into second air passage 146. Since the lowermost third air passage 147b is opposed to lower vent 114, the air flowing through second air passage 146 can reach every corner of radiation board member 153.

Blowers 110 forcibly circulate the air present inside covers 108 through radiation air passages 122 such that the heat generated by control units 107 is conducted to heat exchangers 111.

This results in an increase in the temperature inside heat exchangers 111 outside partition board 109, that is, inside first, second, and third air passages 145, 146, and 147. As a result, a temperature gradient is established between the inside of heat exchangers 111 and the outside of display device 101 by the synthetic resin boards. The temperature gradient creates air natural convection inside rear cover 103. The natural convection allows the air to flow through radiation frames 151 of heat exchangers 111, and then to flow upward through the top surface of rear cover 103, thereby becoming an ascending air current. As a result, the outside air comes in through the bottom surface of rear cover 103 so as to accelerate the natural convection, thereby providing high heat radiation effect. The temperature rise in heat exchangers 111 creates micro convections 121a between convection passages 121 and the outside air through vent holes 154. Micro convections 121a are local convections as shown in Fig. 33A. The air flowing in and out in radiation frames 151 due to micro convections 121a accelerates the heat radiation effect in heat exchangers 111, that is, in display device 101. If rear cover 103 has a mesh or grid pattern to allow air through, micro convections 121a further accelerate the heat radiation effect.

Heat exchangers 111 are lightweight because they are synthetic resin boards, more particularly, polystyrene resin boards. Heat exchangers 111 made of polystyrene resin are much lighterweight especially than heatsinks, which are currently employed as radiating parts and are mainly composed of aluminum.

Since having a circular cross section, connection columns 150 facilitate the airflow from first air passages 145 to second air passages 146, thereby increasing the amount of air flowing through radiation air passages 122.

Particularly when partition board 109 is made of a material with high thermal conductivity such as metal, the heat of heating parts 125 is conducted to partition board 109 directly via thermal conductive members 124, and then to heat exchangers 111. Thus, the heat of heating parts 125 is efficiently radiated.

In the present eleventh exemplary embodiment, the large number of connection columns 150 are arranged in straight rows and columns at predetermined intervals in the grid pattern on base plates 152, but may alternatively be arranged in a checkerboard pattern. In this case, to ensure the air passages for natural convection created inside rear cover 103, connection columns 150 are preferably arranged at intervals 1.4 times as long as those arranged in the grid pattern.

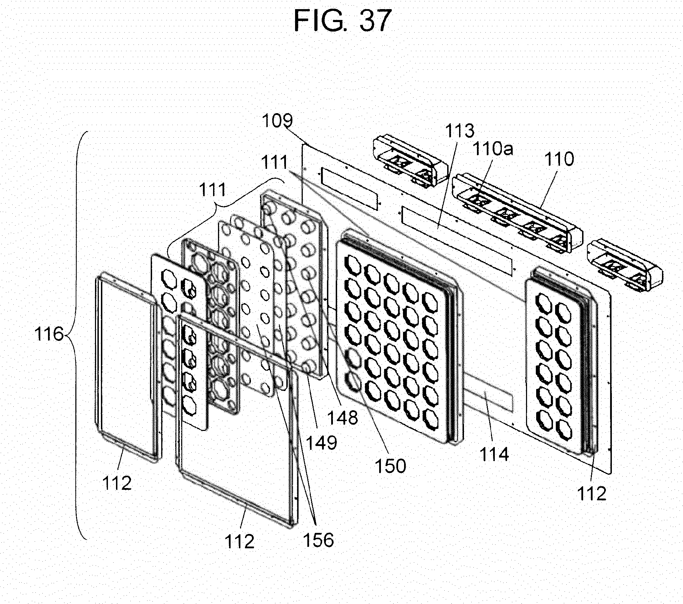

Fig. 37 is an exploded perspective view of the cooling units of another electronic device according to the eleventh exemplary embodiment. Each heat exchanger 111 may be provided with fins 156 on the outer peripheries of connection columns 150 so as to increase the heat transfer area of convection passages 121. The presence of fins 156 on the outer peripheries of connection columns 150 improves the heat radiation effect.

### TWELFTH EXEMPLARY EMBODIMENT

In a twelfth exemplary embodiment, the same components as in the fourth and eleventh exemplary embodiments are denoted by the same reference numerals, and hence the description thereof will be omitted. The following description will be focused on the differences. While a single shield wall 155 is provided in each heat exchanger in the eleventh exemplary embodiment, a plurality of shield walls 155 are provided in each heat exchanger in the present twelfth exemplary embodiment.

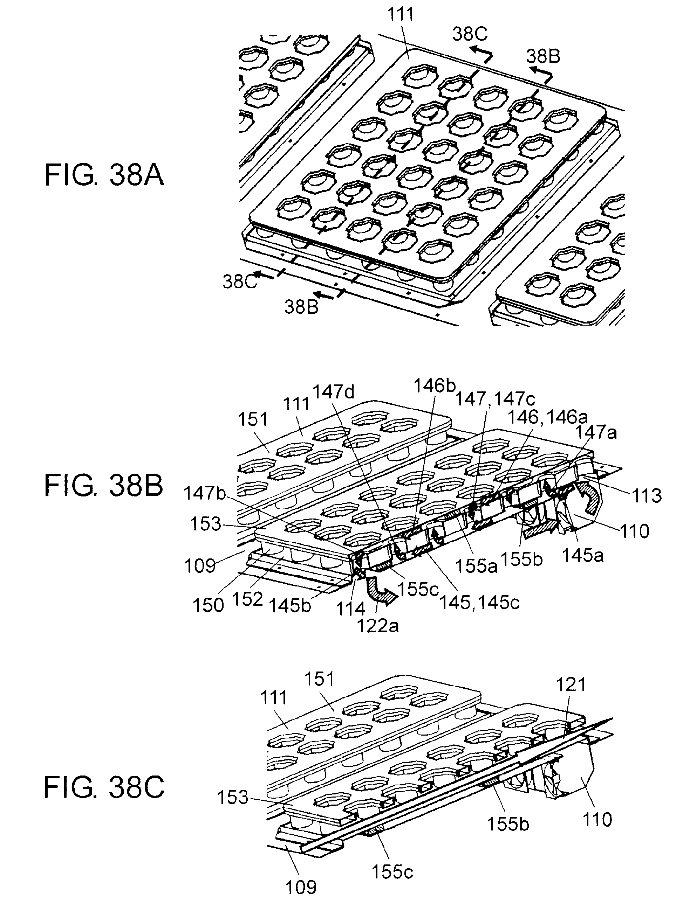

Fig. 38A is an overview of the heat exchangers of the cooling units of an electronic device according to the twelfth exemplary embodiment. Fig. 38B is a view taken along line 38B-38B of Fig. 38A. Fig. 38C is a view taken along line 38C-38C of Fig. 38A.

In each cooling unit of the electronic device of the present twelfth exemplary embodiment, heat exchanger 111 includes shield walls 155a, 155b, and 155c. Shield wall 155a is disposed in radiation board member 153 so as to partition second air passage 146 into two parts. Shield walls 155b and 155c are disposed between partition board 109 and base plate 152 so as to partition first air passage 145 into three parts. Thus, second air passage 146 is partitioned into second air passage 146a beside upper vent 113 and second air passage 146b beside lower vent 114 by shield wall 155a.

First air passage 145 includes first air passages 145a, 145b, and 145c. First air passage 145a is formed beside upper vent 113 by disposing shield wall 155b beside upper vent 113. First air passage 145b is formed beside lower vent 114 by disposing shield wall 155c beside lower vent 114. First air passage 145c is formed between shield walls 155b and 155c.

Third air passage 147 includes third air passages 147c and 147d. Third air passage 147c communicates between first and second air passages 145c and 146a. Third air passage 147d communicates between first and second air passages 145c and 146b. Thus, first air passage 145 is provided with horizontally long shield walls 155b and 155c, whereas second air passage 146 is provided with horizontally long shield wall 155a. First air passage 145 is provided with one more shield wall than second air passage 146. Therefore, the air drawn in from an opening and drawn out from the other opening can flow from first air passage 145 to second air passage 146 via third air passages 147 at least twice. The air inside display device 101 as the electronic device is forced into heat exchangers 111, and a large amount of heat is radiated to the outside of display device 101 via heat exchangers 111.

Thus, shield walls 155a, 155b, and 155c together form radiation air passage 122a in each heat exchanger 111. Radiation air passage 122a consists of upper vent 113, first air passage 145a, third air passage 147a, second air passage 146a, third air passage 147c, first air passage 145c, third air passage 147d, second air passage 146b, third air passage 147b, first air passage 145b, and lower vent 114, which are connected in that order. When air is flown through radiation air passage 122a, the air flows twice between base plate 152 and radiation board member 153. As a result, the surface area of convection passages 121 to radiate heat outside display device 101 becomes larger than in the eleventh exemplary embodiment.

With this structure, a temperature gradient is established between the air inside and outside of display device 101 by the synthetic resin boards. The temperature gradient creates air natural convection inside rear cover 103. The natural convection allows the air to flow through radiation frames 151 of heat exchangers 111, and then to flow upward through the top surface of rear cover 103, thereby becoming an ascending air current. As a result, the outside air comes in through the bottom surface of rear cover 103 so as to accelerate the natural convection, thereby providing high heat radiation effect.

In the present twelfth exemplary embodiment, first air passage 145 has two shield walls, and second air passage 146 has one shield wall, but the number of shield walls is not limited to them. Any number of shield walls can be disposed between connection columns 150 according to the arrangement of connection columns 150 forming third air passages 147 to provide high heat radiation effect.

The number of shield walls in first air passage 145 needs to be one larger than the number of shield walls in second air passage 146.

This allows the air entered through upper vent 113 to flow between first air passage 145 and second air passage 146 in each heat exchanger 111, while radiating the heat, and is again drawn into display device 101 through lower vent 114. The number of times that the air flows between first and second air passages 145 and 146 is determined by the number of shield walls disposed in first air passage 145.

### THIRTEENTH EXEMPLARY EMBODIMENT

In a thirteenth exemplary embodiment, the same components as in the fourth and eleventh exemplary embodiments are denoted by the same reference numerals, and hence the description thereof will be omitted. The following description will be focused on the differences.

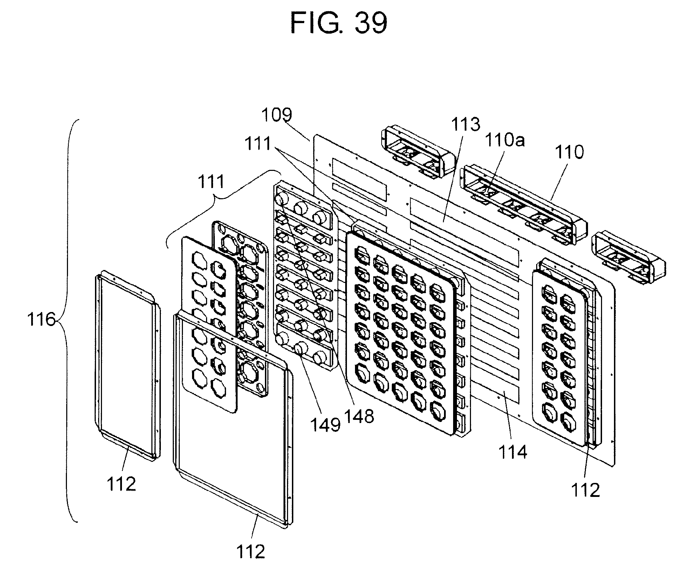

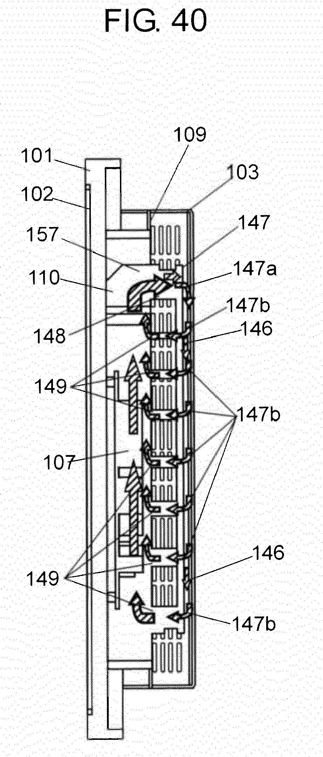

Fig. 39 is an exploded perspective view of the cooling units of an electronic device according to the thirteenth exemplary embodiment. Fig. 40 is a sectional side view of the cooling units. As shown in Figs. 39 and 40, each heat exchanger 111 blows air into display device 101 through a plurality of third air passages 147b without passing through lower vent 114.

As shown in Fig. 40, partition board 109 has horizontally long guides 157 in place of the upper vents, and does not have lower vents 114. Guides 157 allow the air from blowers 110 to be flown into heat exchangers 111. Thus, heat exchangers 111 of the present thirteenth exemplary embodiment are not provided with first air passages 145 or shield walls 155 provided in the eleventh exemplary embodiment.

In Fig. 40, third air passages 147 consist of third air passages 147a and 147b. Third air passages 147a are communicated with blowers 110 as in the eleventh exemplary embodiment. Third air passages 147b blow air directly into display device 101. Third air passages 147a have inlet ports 148 which are opposed to the exhaust ports of blowers 110, and outlet ports 149 through which air is blown into display device 101. Third air passages 147b increase in cross sectional area with distance from third air passages 147a.

More specifically, at least the uppermost third air passage 147, which is third air passage 147a, has inlet port 148, and third air passages 147b below third air passages 147a gradually increase in cross sectional area. Considering heat radiation in convection passages 121, it is preferable that the cross section of third air passages 147b of radiation air passages 122 increase in vertical width and are the same in horizontal width. Thus, third air passages 147 are formed so that connection columns 150 adjacent in the vertical and horizontal directions have the same projection geometry. As a result, in spite of the change in the cross sectional area of third air passages 147b, the air flowing through convection passages 121 flows upward in secure contact with connection columns 150, thereby ensuring the heat radiation effect due to natural convection.

With this structure, the air drawn into inlet ports 148 by blowers 110 through guides 157 flows from third air passages 147a into second air passages 146. The air blown from third air passages 147b again into display device 101 circulates through display device 101 and heat exchangers 111. Then, the air repeatedly exchanges heat with the air inside convection passages 121 via the boards composing heat exchangers 111, thereby radiating the heat from display device 101 to the outside.

In the present thirteenth exemplary embodiment, at least the uppermost third air passage 147, which is third air passage 147a, includes inlet port 148, and third air passages 147b increase in cross sectional area with each line. The distribution of the air passage resistance is adjusted by the cross sectional area of third air passages 147b so as to eliminate the difference between the third air passages close to and distant from inlet port 148. As a result, the air can be evenly blown from outlet port 149 into display device 101.

Thus, since the cross section of third air passages 147b of radiation air passages 122 change in the vertical direction, connection columns 150 in a row are prevented from being in the shadows of connection columns 150 in the next row in convection passages 121. This allows the convected air to flow upward, moving closely around all connection columns 150. As a result, the heat radiation effect can be larger than in the case where connection columns 150 have a cylindrical shape. In the case where connection columns 150 have a cylindrical shape, the air flowing through convection passages 121 is prevented from coming into contact with upper connection columns 150 because lower connection columns 150 are in the shadows of upper connection columns 150.

### FOURTEENTH EXEMPLARY EMBODIMENT

In a fourteenth exemplary embodiment, the same components as in the fourth and eleventh exemplary embodiments are denoted by the same reference numerals, and hence the description thereof will be omitted. The following description will be focused on the differences.

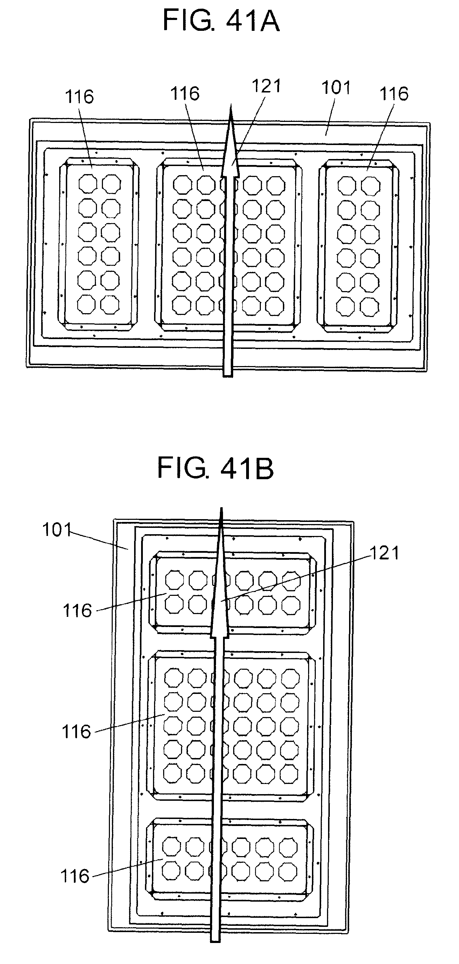

Figs. 41A and 41B are rear views of the display unit of an electronic device according to the fourteenth exemplary embodiment when the display unit is placed in landscape and portrait orientation, respectively.

Display unit 102 is usually placed so that it is longer in the horizontal direction than in the vertical direction as shown in Fig. 41A. In this case, the air flows through radiation frames 151 of heat exchangers 111 in the lateral direction of display device 101, thereby radiating the heat.

When used for advertisement, commodity information transmission, or as a poster, display device 101 may be placed in portrait orientation as shown in Fig. 41B depending on the site where display device 101 is installed. For this reason, display device 101 is required to be able to radiate heat from it according to the status of use, regardless of whether it is placed in landscape or portrait orientation.

In the eleventh and twelfth exemplary embodiments, connection columns 150 are arranged in a grid pattern in radiation frames 151. Rear cover 103 has a mesh or grid pattern on its top, bottom, and side surfaces, allowing air through. Therefore, whether display device 101 is placed in landscape or portrait orientation, convection passages 121 can be ensured, and the heat radiation effect of heat exchangers 111 can be also ensured. Radiation air passages 122 in heat exchangers 111 are not affected by the direction in which display device 101 is placed because air is forced thereinto by blowers 110.

Thus, cooling units 116 attached to the back surface of the electronic device is not affected whether display device 101 is placed in landscape or portrait orientation, allowing the heat generated in the electronic device to be forcibly exhausted.

### FIFTEENTH EXEMPLARY EMBODIMENT

In a fifteenth exemplary embodiment, the same components as in the fourth and ninth exemplary embodiments are denoted by the same reference numerals, and hence the description thereof will be omitted. The following description will be focused on the differences.

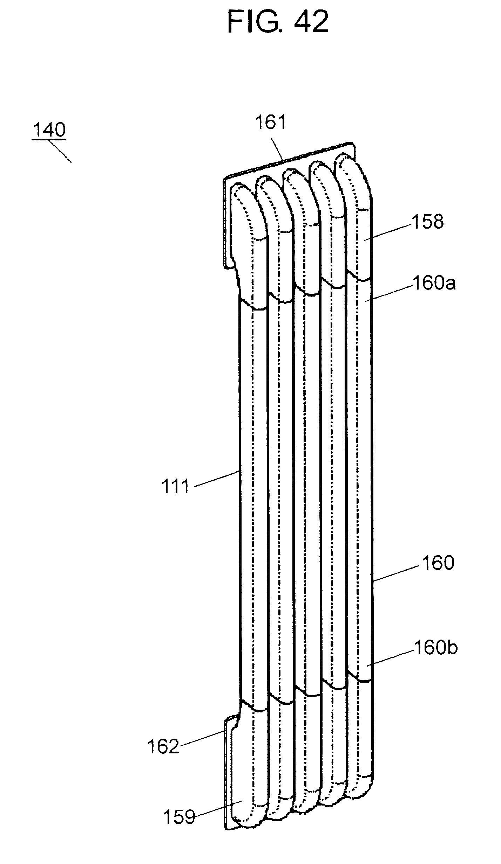

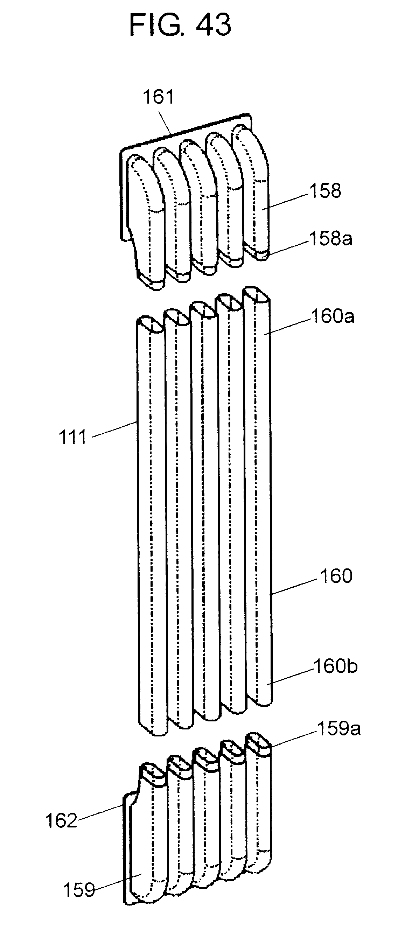

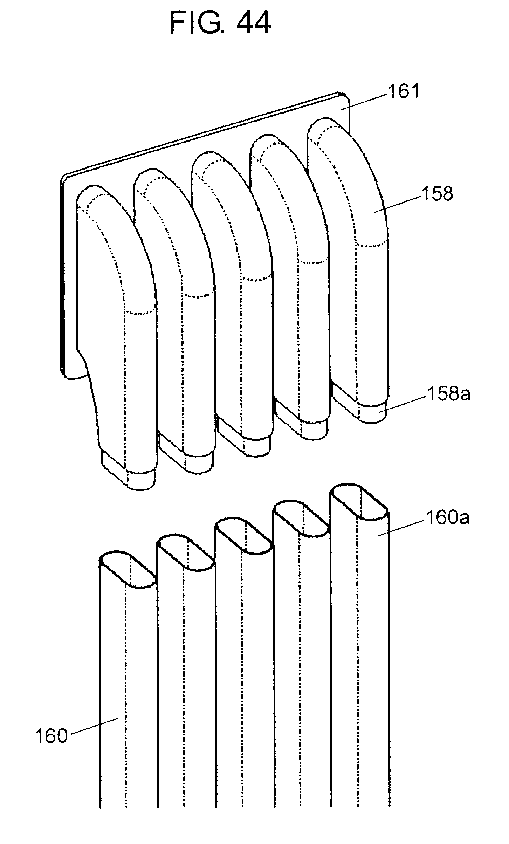

Fig. 42 is a perspective view of a cooling unit of an electronic device according to the fifteenth exemplary embodiment. Fig. 43 is an exploded perspective view of a cooling unit of the electronic device. Fig. 44 is an enlarged exploded perspective view of a cooling unit of the electronic device.

Each hot-air passage body 140 includes upper air-passage body 158, lower air-passage body 159, and intermediate air-passage body 160. Upper and lower air-passage bodies 158 and 159 are connected to upper and lower vents 113 and 114, respectively. Intermediate air-passage body 160 connects upper and lower air-passage bodies 158 and 159.

Upper air-passage bodies 158 are integrally molded with attachment plate 161, which is attached to the outer surface of partition board 109. Lower air-passage body 159 is integrally molded with attachment plate 162, which is attached to the outer surface of partition board 109.

Each upper air-passage body 158 is provided at its bottom with lower-end insertion part 158a, which is configured to be inserted into intermediate-air-passage-body upper end 160a of intermediate air-passage body 160. Each lower air-passage body 159 is provided at its top with upper-end insertion part 159a, which is configured to be inserted into intermediate-air-passage-body lower end 160b of intermediate air-passage body 160.

Lower-end insertion part 158a of upper air-passage body 158 is inserted into intermediate-air-passage-body upper end 160a. Upper-end insertion part 159a of lower air-passage body 159 is inserted into intermediate-air-passage-body lower end 160b. As shown in Fig. 42, in each hot-air passage body 140, upper air-passage body 158, intermediate air-passage body 160, and lower air-passage body 159 are integrated each other.

Lower-end insertion part 158a of upper air-passage body 158 and intermediate-air-passage-body upper end 160a are bonded via an adhesive (not shown). In the same manner, upper-end insertion part 159a of lower air-passage body 159 and intermediate-air-passage-body lower end 160b are bonded via the adhesive. This prevents hot-air passage bodies 140 from being subjected to air leakage or rain infiltration through these joints. One preferable example of the adhesive is a caulking material, which can effectively prevent rain infiltration into hot-air passage bodies 140.

The following is a description of the wall thicknesses and other properties of upper, lower, and intermediate air-passage bodies 158, 159, and 160 composing hot-air passage bodies 140.

Upper, lower, and intermediate air-passage bodies 158, 159, and 160 are all made of synthetic resin. Intermediate air-passage bodies 160 are made thinner than upper and lower air-passage bodies 158 and 159, and than upper-end and lower-end insertion parts 159a and 158a.

Upper and lower air-passage bodies 158 and 159 are integrally molded with attachment plates 161 and 162, respectively, which are attached to the outer surface of partition board 109. Therefore, upper and lower air-passage bodies 158 and 159 are required to be thick enough to be securely attached to partition board 109.

Lower-end and upper-end insertion parts 158a and 159a are made slightly thin to be easily inserted into intermediate air-passage bodies 160, but are still thicker than intermediate air-passage bodies 160.

Intermediate air-passage bodies 160 are made thinner than upper and lower air-passage bodies 158 and 159. As a result, intermediate air-passage bodies 160 can be easily vibrated by the air current passing through them, thereby protecting their outer surfaces from dust and insects. Thus, the outer surfaces of intermediate air-passage bodies 160 are kept clean, thereby providing high heat radiation effect.

The above-described effect can be enhanced by making intermediate air-passage bodies 160 more flexible than upper and lower air-passage bodies 158 and 159.

As described above, in the present fifteenth exemplary embodiment, there is no need to provide fins inside display device 101 unlike conventional cases. The heat inside display device 101 is blown by blowers 110 to heat exchangers 111 disposed outside display device 101, thereby effectively radiating the heat. As a result, the electronic device can be lightweight.

In the present fifteenth exemplary embodiment, in each heat exchanger 111, hot-air passage bodies 140 vertically extend like bridges to connect a plurality of upper vents 113 and a plurality of lower vents 114 on the outer side of partition board 109, that is, outside display device 101. As described above, each hot-air passage body 140 consists of upper air-passage body 158 connected to upper vent 113, lower air-passage body 159 connected to lower vent 114, and intermediate air-passage body 160 connecting upper and lower air-passage bodies 158 and 159. The size of heat exchangers 111 can be easily changed according to the size of display device 101. Thus, display devices can be available in various sizes by changing only the length of intermediate air-passage bodies 160 of hot-air passage bodies 140 to achieve extremely high productivity.

### SIXTEENTH EXEMPLARY EMBODIMENT

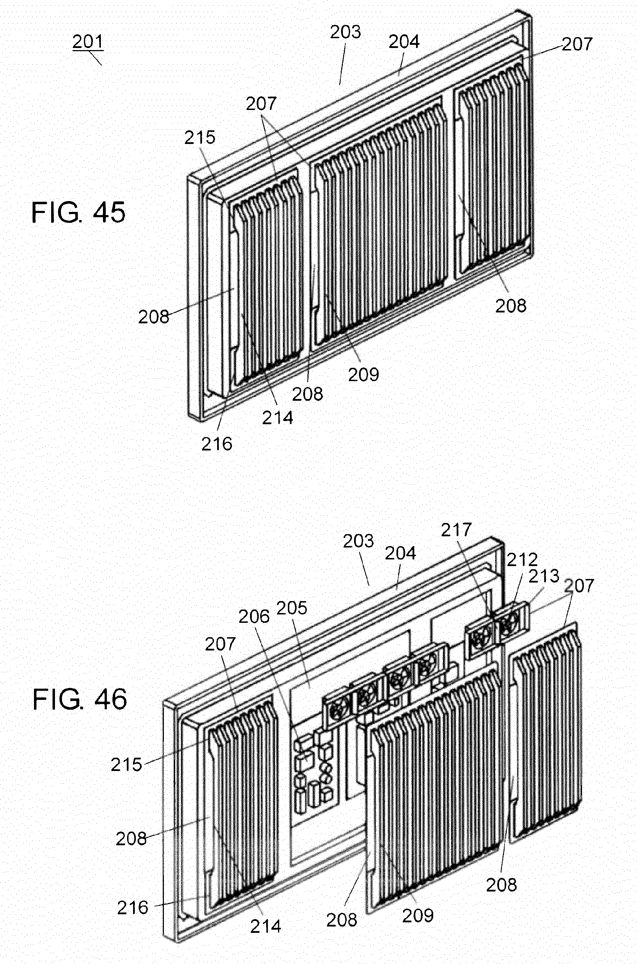

Fig. 45 is a rear perspective view of an electronic device according to a sixteenth exemplary embodiment of the present invention. Fig. 46 is an exploded rear perspective view of the electronic device. Display device 201, which is an example of the electronic device, includes body case 204, display unit 203, radiation boards 205 disposed inside body case 204, high-temperature heating members 206, and cooling units 207. Body case 204 is open on both front and back sides. Display unit 203 is disposed in such a manner that the front opening of body case 204 is sealed. Cooling units 207 are disposed in such a manner as to seal the back openings of body case 204.

As shown in Fig. 45, in the present sixteenth exemplary embodiment, three cooling units 207 are arranged from side to side in such a manner as to seal the back openings of body case 204.

Radiation boards 205 are placed behind display unit 203 and are heated by the heat from display unit 203.

High-temperature heating members 206 such as electronic components are placed on radiation boards 205 so as to control display unit 203.

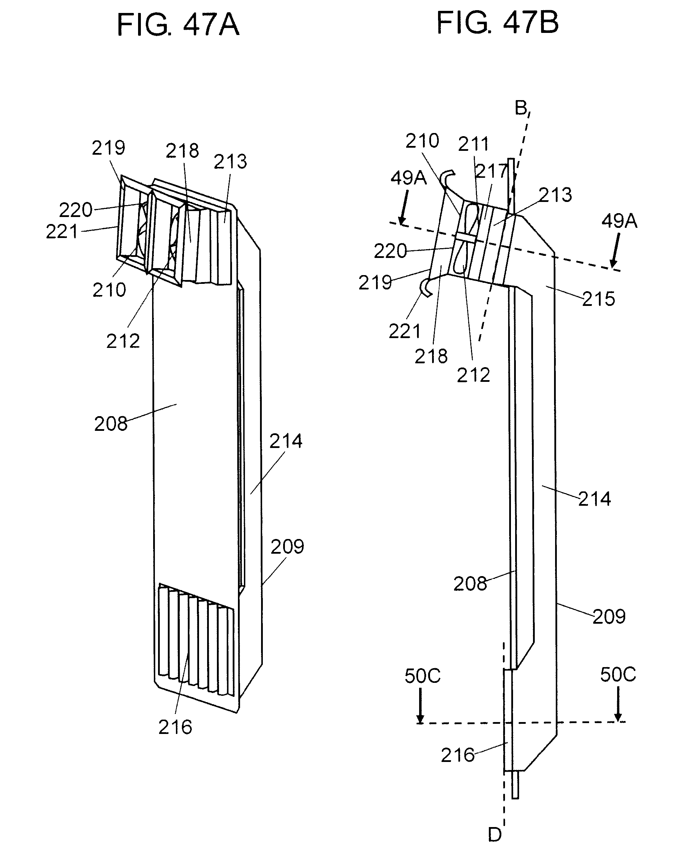

Fig. 47A is a perspective view of a part of a cooling unit of the electronic device according to the sixteenth exemplary embodiment. Fig. 47B is a sectional view of a cooling unit of the electronic device. As shown in Figs. 46, 47A, and 47B, each cooling unit 207, which is disposed over each back opening of body case 204, includes partition board 208, a number of heat exchangers 209, blowers 212 and first space 213. Partition board 208 sealingly partitions the inside and outside of body case 204. Heat exchanger 209 is disposed on the outer side of body case 204. Each blower 212 includes blower air inlet 210 and blower air outlet 211. First space 213 is formed between heat exchanger 209 and blowers 212.

Each heat exchanger 209 includes vertically long air passageways 214, circulating air inlets 215 as first vents, and circulating air outlets 216 as second vents. Circulating air inlets 215 and circulating air outlets 216 are formed at opposite ends of air passageways 214. Each heat exchanger 209 has a cylindrical shape in which air passageways 214 vertically extend to connect between circulating air inlets 215 and circulating air outlets 216 outside body case 204.

As shown in Fig. 46, heat exchangers 209 are arranged horizontally side by side at predetermined intervals. Heat exchangers 209 are vertically straight, and therefore, circulating air inlets 215 and circulating air outlets 216 are also arranged horizontally side by side at predetermined intervals.

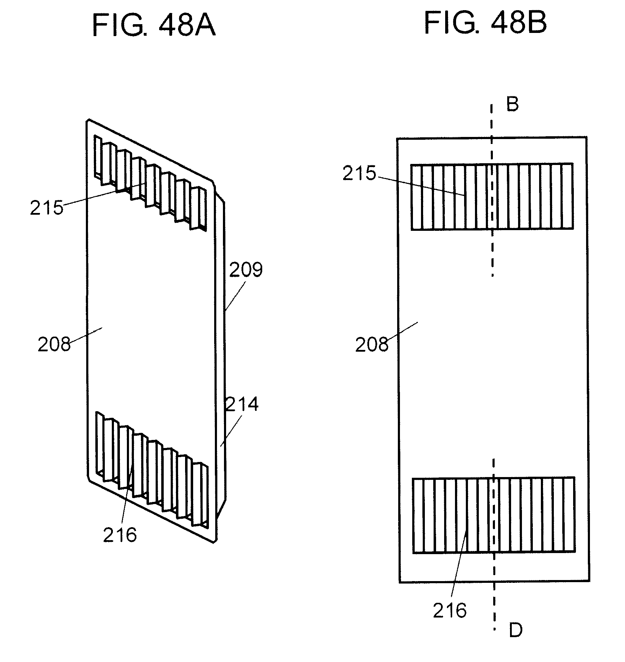

Fig. 48A is a perspective view of a heat exchanger and a partition board in a cooling unit of the electronic device according to the sixteenth exemplary embodiment. Fig. 48B is a front view of a heat exchanger and a partition board of a cooling unit of the electronic device. Each partition board 208 includes a horizontally long upper opening and a horizontally long lower opening. The upper opening allows circulating air to be drawn into heat exchanger 209, and the lower opening allows the circulating air to be drawn out of the heat exchanger.

The upper opening includes a plurality of circulating air inlets 215, and the lower opening includes a plurality of circulating air outlets 216.

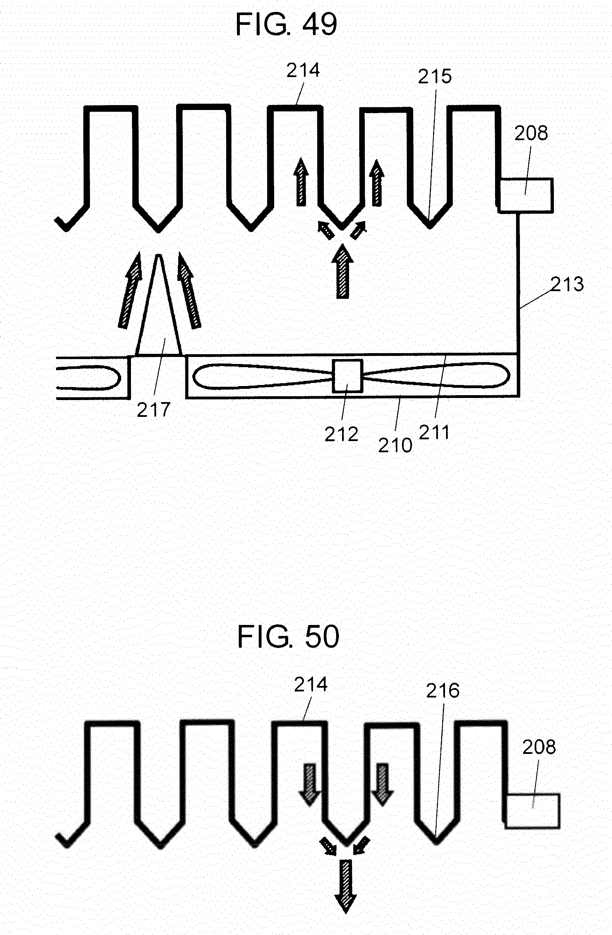

Fig. 49 is a view taken along line 49A-49A of Fig. 47B. Line 49A-49A of Fig. 47B is perpendicular to the center line "B" of circulating air inlets 215 shown in Fig. 48B, and crosses circulating air inlets 215. Fig. 49 also shows the detail of partition parts 217 and air passageways 214.

Partition part 217 is formed to partition circulating air blown from adjacent blowers 212 in first space 213.

On the circulating air inlet 215 side, air passageways 214 increase in width from downstream to upstream.

Fig. 50 is a view taken along line 50C-50C of Fig. 47B. Line 50C-50C of Fig. 47B is perpendicular to the center line "D" of circulating air outlets 216 shown in Fig. 48B and crosses circulating air outlets 216. Fig. 50 also shows the detail of air passageways 214.

On the circulating air outlet 216 side, air passageways 214 increase in width from upstream to downstream.

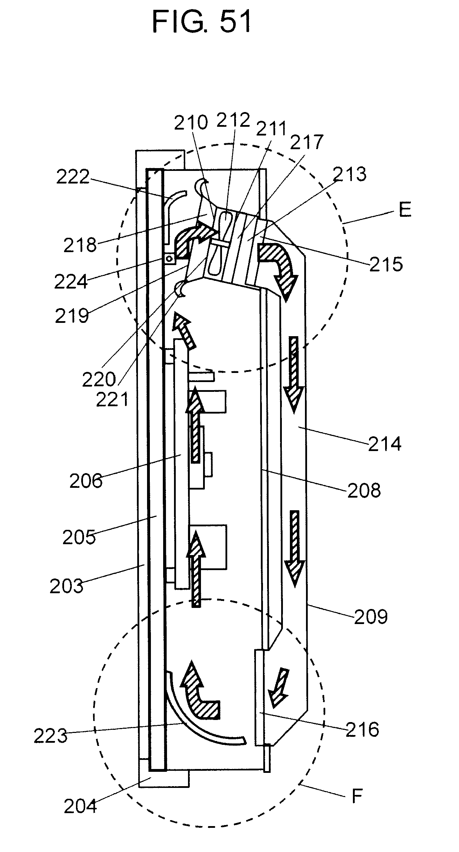

Fig. 51 is a sectional view of the electronic device according to the sixteenth exemplary embodiment. The circulating air in body case 204 is blown out by blowers 212, and is drawn into heat exchangers 209 through circulating air inlets 215. The drawn circulating air circulates through air passageways 214, and is blown into body case 204 through circulating air outlets 216. The drawn circulating air circulates through high-temperature heating members 206, and is again drawn into blowers 212. Thus, the circulating air circulates through body case 204 and heat exchangers 209.

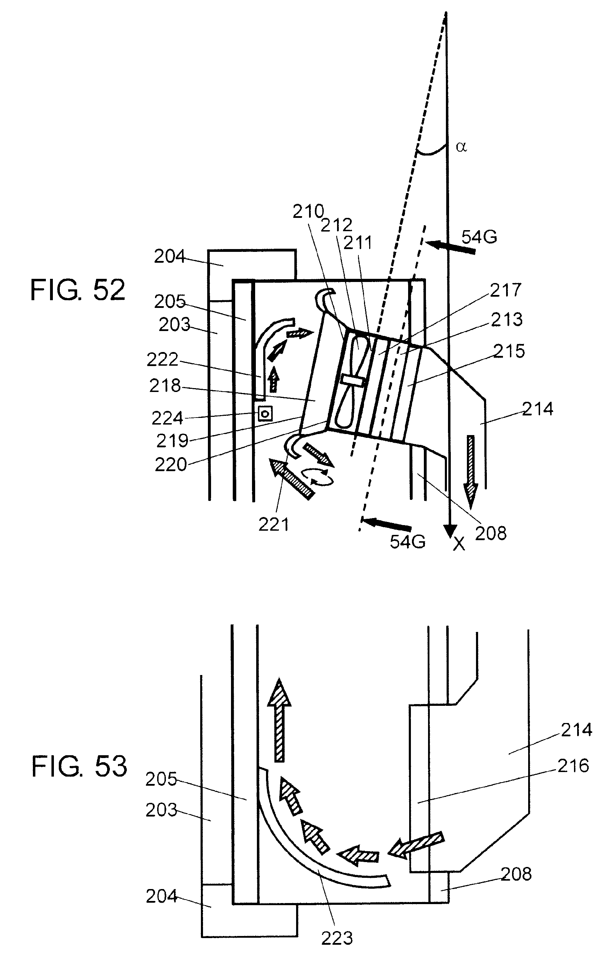

Fig. 52 is an enlarged view of part "E" of Fig. 51. Blowers 212, which are axial blowers, are disposed at an inclination angle α with respect to the direction "X" of the circulation of air passageways 214 from the surface of body case 204 on which cooling units 207 are disposed. The circulating air in body case 204 is drawn into heat exchangers 209 through circulating air inlets 215.

On each blower air inlet 210, there is provided cylindrical rectifier air passage 218, which has rectifier-air-passage inlet 219 on the upstream side of the circulating air, and rectifier-air-passage outlet 220 on the downstream side of the circulating air. Rectifier-air-passage inlet 219 has a larger opening area than rectifier-air-passage outlet 220.

Rectifier-air-passage inlet 219 is provided with rectifier unit 221 extending in the direction of the contour of blower 212. At the upstream of each circulating air inlet 215, there is provided first rectifier plate 222, which guides the circulating air to circulating air inlet 215. First rectifier plate 222, which is in contact with radiation board 205, are made of a highly heat-conductive material such as metal.

Fig. 53 is an enlarged view of part "F" of Fig. 51. At the downstream of each circulating air outlet 216, there is provided second rectifier plate 223, which guides the circulating air to high-temperature heating member 206. Second rectifier plate 223, which is in contact with radiation board 205, is made of a highly heat-conductive material such as metal.

As shown in Fig. 51, at the upstream of each circulating air inlet 215, there is provided circulating air temperature measuring means 224 such as a thermistor, which measures the temperature of the circulating air drawn into circulating air inlet 215.

In the present sixteenth exemplary embodiment, the front and back openings of body case 204 are sealed by display unit 203 and partition boards 208, respectively. This causes the heat from display unit 203 and high-temperature heating members 206 to be trapped in body case 204.

This is the reason the above-described cooling units 207 are provided in the present sixteenth exemplary embodiment. When blowers 212 are driven, as shown in Fig. 51, the heat in body case 204 is exhausted as hot air through circulating air inlets 215 into heat exchangers 209, that is, to the outside of body case 204. Later, the hot air cooled while passing through heat exchangers 209 is drawn into body case 204 through circulating air outlets 216, thereby cooling high-temperature heating members 206.

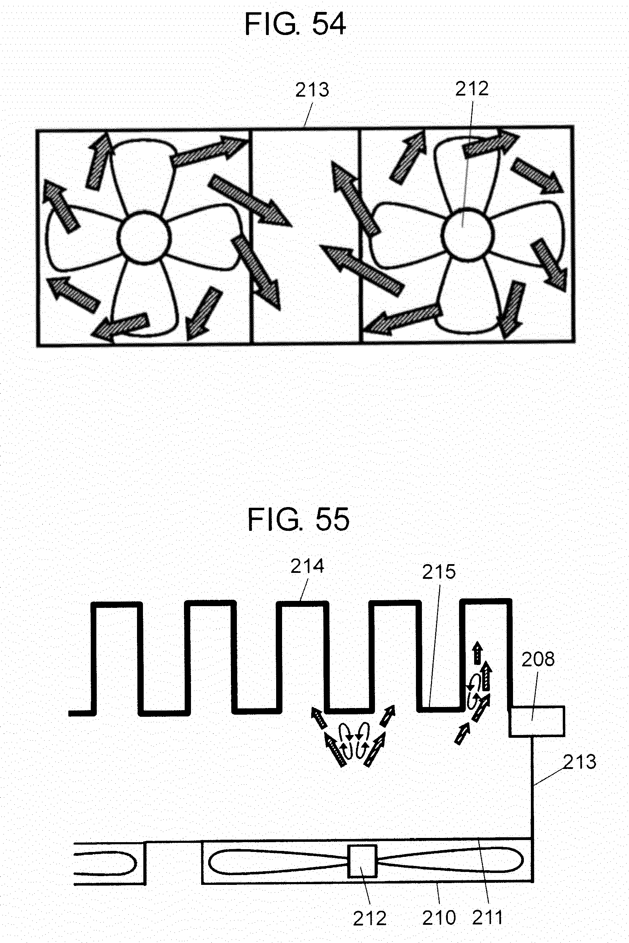

Fig. 54 is a view taken along line 54G-54G of Fig. 52. Fig. 54 shows the detail of blowers 212, and the cross section along line 54G-54G, which is parallel to the surfaces of blower air outlets 211 and crosses first space 213.

As shown in Fig. 49, partition parts 217 are formed in first space 213. This avoids interference between the circulating air blown from a blower 212 and the circulating air blown from an adjacent blower 212 as shown in Fig. 54. This allows the ventilation resistance and power consumption of blowers 212 to be low.

As shown in Fig. 49, on the circulating air inlet 215 side, air passageways 214 increase in width from downstream to upstream. This prevents a rapid change in the cross sectional area from body case 204 to air passageways 214, thereby reducing whirlwind caused by the collision of the circulating air against the region between air passageways 214. As a result, the inrush resistance is low when the circulating air rushes into circulating air inlets 215, thereby allowing the ventilation resistance and power consumption of blowers 212 to be low.

The inrush resistance caused by the rushing of the circulating air consists of two ventilation resistances as shown in Fig. 55, which is a view to be compared with the shape of the air passageways of Fig. 49. One of the ventilation resistances is due to the whirlwind caused by the viscous circulating air in the vicinity of the outside of circulating air inlets 215 immediately before the circulating air is drawn into heat exchangers 209. The other is due to the whirlwind caused by the viscous circulating air in the vicinity of the inside of circulating air inlets 215 immediately after the circulating air is drawn into heat exchangers 209.

As shown in Fig. 50, on the circulating air outlet 216 side, air passageways 214 increase in width from upstream to downstream. This prevents an increase in blowout resistance due to the rapid increase in air passageways 214 when the circulating air is blown out from circulating air outlets 216, allowing the ventilation resistance and power consumption of blowers 212 to be low.

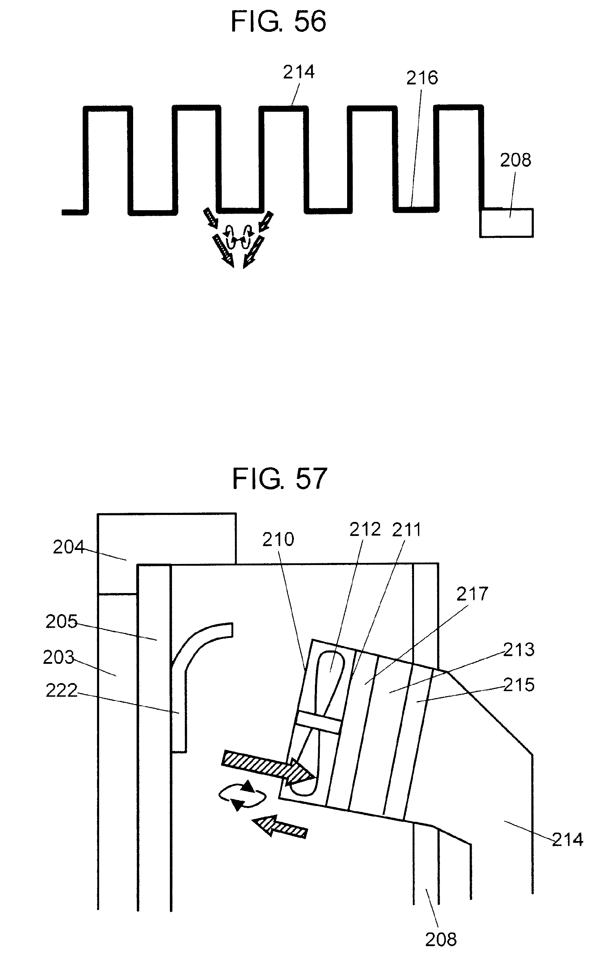

The blowout resistance means a ventilation resistance due to the whirlwind in the vicinity of circulating air outlets 216, which is caused immediately after the circulating air is blown out from heat exchangers 209 as shown in Fig. 56, which is a view to be compared with the shape of the air passageways of Fig. 50.

As shown in Fig. 52, blowers 212, which are axial blowers, are disposed at an inclination angle α with respect to the direction "X" of the circulation of air passageways 214 from the surface of body case 204 on which cooling units 207 are disposed. Compared with the case of disposing blowers 212 with no inclination, the change in the direction of the circulation is small when the circulating air blown from blowers 212 circulates through air passageways 214. As a result, the ventilation resistance and power consumption of blowers 212 can be low.

As shown in Fig. 57, which is a view to be compared with Fig. 52 showing the enlarged lower air inlet and its vicinity, in the vicinity of the outside of blower air inlet 210, a whirlwind is caused by the circulating air flowing in the same direction as blower 212 draws air in, and by the circulating air flowing in the other directions. The whirlwind affects blower 212 and increases the suction flow resistance.

To cope with this situation, as shown in Fig. 52, blower air inlets 210 are provided with rectifier air passages 218. This allows whirlwinds to be generated in the vicinity of the outside of rectifier-air-passage inlets 219 instead of in the vicinity of the outside of blower air inlets 210. Thus, the whirlwinds can be kept away from blower air inlets 210 and therefore be less influential to blowers 212. In addition, the circulating air in the vicinity of blower air inlets 210 becomes less disturbed, allowing the suction flow resistance and power consumption of blowers 212 to be low.

Rectifier-air-passage inlets 219 have a lager opening area than rectifier-air-passage outlets 220. This decreases the speed of the circulating air in the vicinity of the outside of rectifier-air-passage inlets 219, thereby reducing the size of the whirlwinds to be caused. The circulating air is drawn in along rectifier air passages 218, preventing an increase in the ventilation resistance in rectifier air passages 218. This provides high rectification effect, allowing the ventilation resistance and power consumption of blowers 212 to be low.

Rectifier-air-passage inlets 219 are provided with rectifier units 221 extending in the direction of the contours of blowers 212. This allows whirlwinds to be generated in the vicinity of the outside of rectifier units 221 instead of in the vicinity of the outside of rectifier-air-passage inlets 219. Thus, the whirlwinds are kept away from blower air inlets 210 so as to provide higher rectification effect, allowing the suction flow resistance and power consumption of blowers 212 to be low.

As shown in Fig. 52, first rectifier plates 222 are provided at the upstream of circulating air inlets 215. This allows the circulating air that has circulated through body case 204 to be drawn into rectifier-air-passage inlets 219 through first rectifier plates 222. Thus, the circulating air that has circulated through body case 204 flows in the same direction as blowers 212 draw air in. This allows the suction flow resistance and power consumption of blowers 212 to be low.

First rectifier plates 222, which are in contact with radiation boards 205, are made of a highly heat-conductive material such as metal. Therefore, first rectifier plates 222 conduct, like fins, the heat of radiation boards 205 directly to the circulating air. As a result, in the electronic device, heat is efficiently radiated from first rectifier plates 222 with only a small amount of circulating air, allowing the power consumption of blowers 212 to be low.

As shown in Fig. 53, the presence of second rectifier plates 223 allows the circulating air blown out from circulating air outlets 216 to circulate along second rectifier plates 223. Thus, the circulating air blown out from circulating air outlets 216 smoothly circulates to high-temperature heating members 206, allowing the ventilation resistance and power consumption of blowers 212 to be low.

Second rectifier plates 223, which are in contact with radiation boards 205, are made of a highly heat-conductive material such as metal. Therefore, second rectifier plate 223 conduct the heat of radiation boards 205 directly to the circulating air. As a result, in the electronic device, heat is efficiently radiated from second rectifier plate 223 with only a small amount of circulating air, allowing the power consumption of blowers 212 to be low.

As shown in Fig. 51, circulating air temperature measuring means 224 are provided at the upstream of circulating air inlets 215, so that the temperature of the circulating air drawn into circulating air inlets 215 can be measured, based on which the amount of air to be blown from blowers 212 is controlled.

As a result, blowers 212 can draw a larger amount of circulating air that has circulated through high-temperature heating members 206 in body case 204, allowing heat exchangers 209 to radiate the heat efficiently. This reduces the amount of circulating air required to radiate the heat inside body case 204, allowing the power consumption of blowers 212 to be lower. This also allows blowers 212 to draw in a smaller amount of circulating air that has not circulated through high-temperature heating members 206, allowing the power consumption to blowers 212 to be lower.

In Fig. 49, partition parts 217 and circulating air inlets 215 are spaced from each other. Alternatively, it is possible to connect partition parts 217 and circulating air inlets 215 in order to partition the circulating air blown from one blower 212 from the circulating air blown from adjacent blowers 212, thereby avoiding the interference therebetween. As a result, the ventilation resistance and power consumption of blowers 212 can be low.

In Fig. 52, rectifier units 221 are in the shape of an arc stretching in the direction of the contours. Even if rectifier units 221 extend straight in the direction of the contours, whirlwinds can be generated in the vicinity of the outside of rectifier units 221 instead of in the vicinity of the outside of rectifier-air-passage inlets 219. Thus, the whirlwinds are kept away from blower air inlets 210 so as to provide higher rectification effect, allowing the suction flow resistance and power consumption of blowers 212 to be low.

In Fig. 52, first rectifier plates 222 and radiation boards 205 are spaced from each other. Alternatively, it is possible to connect first rectifier plates 222 and radiation boards 205. In this case, the circulating air that has circulated through body case 204 can flow in the same direction as blowers 212 draw air in. This allows the suction flow resistance and power consumption of blowers 212 to be low.

In Fig. 53, second rectifier plates 223 and radiation boards 205 are spaced from each other. Alternatively, it is possible to connect second rectifier plates 223 and radiation boards 205. In this case, the circulating air blown from circulating air outlets 216 is made to circulate through high-temperature heating members 206, allowing the ventilation resistance and power consumption of blowers 212 to be low.

### SEVENTEENTH EXEMPLARY EMBODIMENT

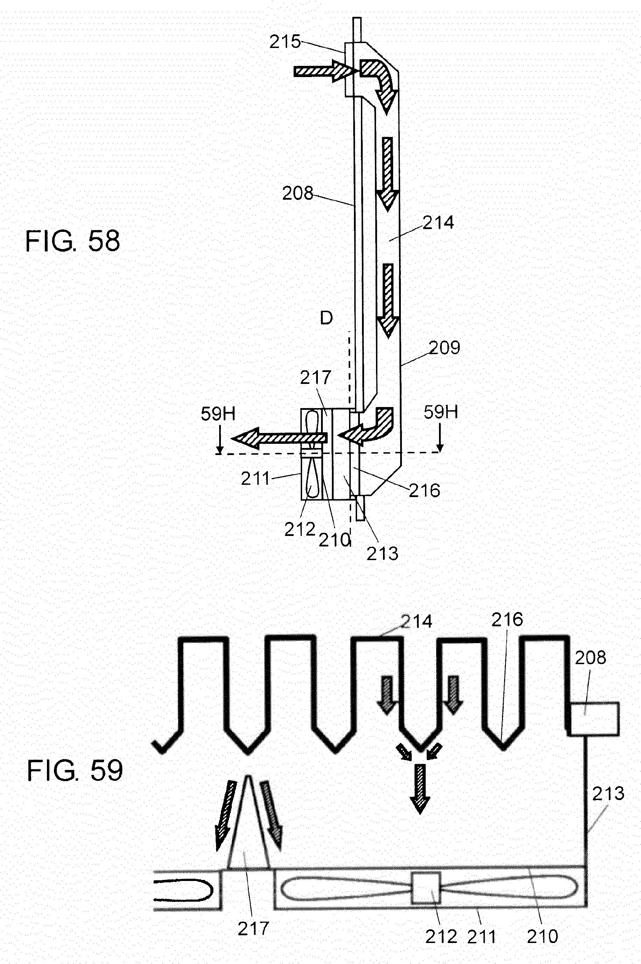

In a seventeenth exemplary embodiment, the same components as in the sixteenth exemplary embodiment are denoted by the same reference numerals, and hence the description thereof will be omitted. The following description will be focused on the differences. Fig. 58 is a sectional view of a cooling unit of an electronic device according to the seventeenth exemplary embodiment.

In the seventeenth exemplary embodiment, a plurality of blowers 212 and first spaces 213 are disposed besides circulating air outlets 216. First spaces 213 are formed between blower air inlets 210 and heat exchangers 209.

Fig. 59 is a view taken along line 59H-59H of Fig. 58. Line 59H-59H is perpendicular to the center line "D" of circulating air outlets 216 shown in Fig. 58 and crosses circulating air outlets 216. Fig. 59 also shows the detail of partition parts 217 and air passageways 214.

As shown in Fig. 59, between two blowers 212 adjacent in first space 213, there is provided partition part 217 which partitions each circulating air to be drawn into blowers 212.

In the present seventeenth exemplary embodiment, as shown in Fig. 58, blowers 212 draw the circulating air from circulating air outlets 216 of heat exchangers 209, thereby circulating the circulating air.

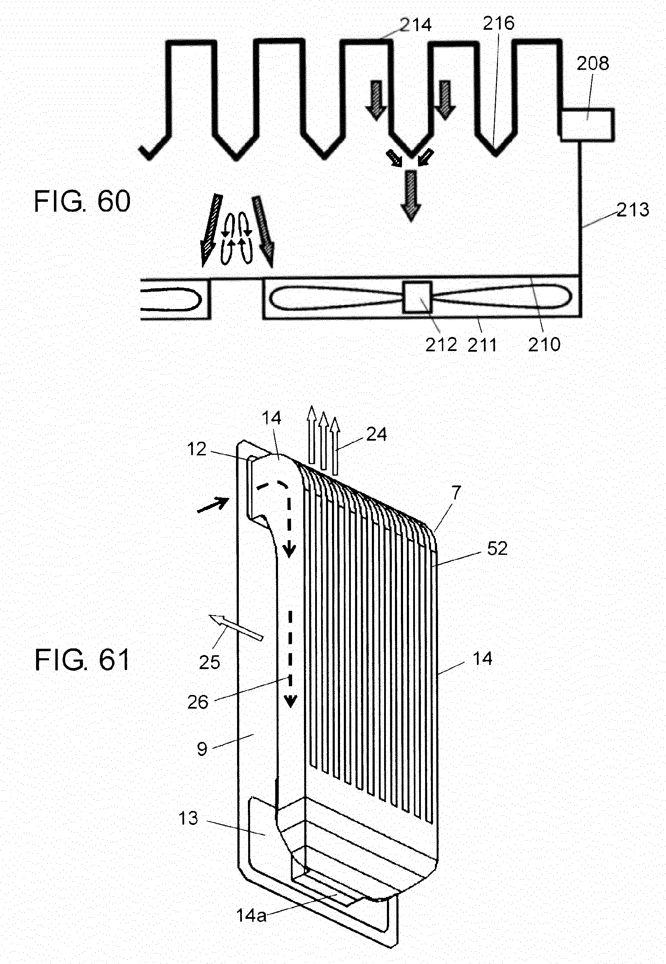

As shown in Fig. 59, partition parts 217 are disposed in first spaces 213 so as to avoid the interference between the circulating air blown from a blower 212 and the circulating air blown from an adjacent blower 212. As shown in Fig. 60, which is a view to be compared with the shape of the air passageways of Fig. 59, the presence of partition parts 217 also prevents an increase in the ventilation resistance due to the whirlwind, which is caused by the circulating air drawn into blowers 212. As a result, the ventilation resistance and power consumption of blowers 212 can be low.

In Fig. 59, partition parts 217 and circulating air outlets 216 are spaced from each other. Alternatively, it is possible to connect partition parts 217 and circulating air outlets 216 in order to partition the circulating air blown from one blower 212 from the circulating air blown from adjacent blowers 212, thereby avoiding the interference therebetween. This structure also prevents an increase in the ventilation resistance due to the whirlwind caused by the circulating air blown into blowers 212 shown in Fig. 60. As a result, the ventilation resistance and power consumption of blowers 212 can be low.

Although not illustrated, also in the present seventeenth exemplary embodiment, first rectifier plates 222 are disposed at the upstream of circulating air inlets 215, and second rectifier plates 223 are disposed at the downstream of circulating air outlets 216. The first and second rectifier plates have the same action and effect as in the sixteenth exemplary embodiment.

### EIGHTEENTH EXEMPLARY EMBODIMENT

In an eighteenth exemplary embodiment of the present invention, the same components as in the first exemplary embodiment are denoted by the same reference numerals, and hence the description thereof will be omitted. The following description will be focused on the differences.

Fig. 61 is a perspective view of the air passages of the heat exchanger of a cooling unit of an electronic device according to the eighteenth exemplary embodiment. In each heat exchanger, hot-air passage bodies 14 consist of vertically long air passages 52, which extend like bridges at predetermined intervals.

Hot-air passage bodies 14 include first air passageways 24, which extend along hot-air passage bodies 14 between upper and lower vents 12 and 13.

Hot-air passage bodies 14 also include second air passageway 25, which crosses the direction of first air passageways 24 between upper and lower vents 12 and 13. Second air passageway 25 extends between partition board 9 and hot-air passage bodies 14. Each hot-air passage body 14 is hollow inside, which functions as third air passageway 26.

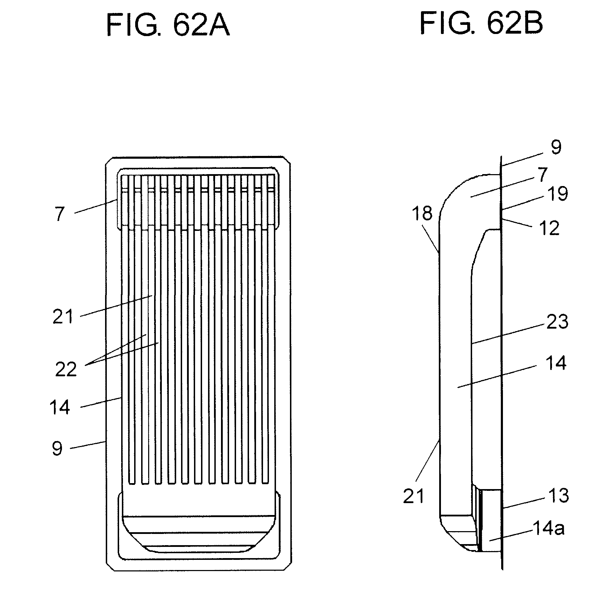

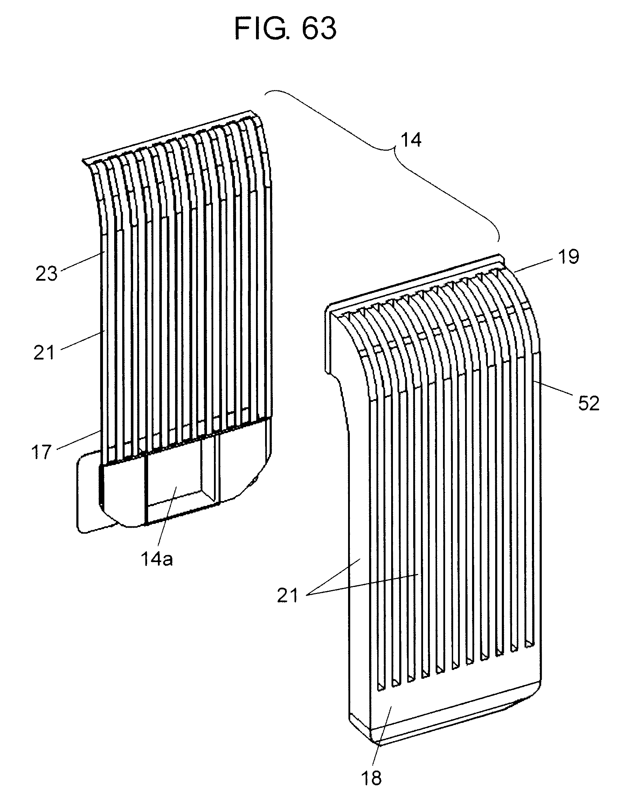

Figs. 62A, 62B, and 63 are front, side, and exploded perspective views of the heat exchanger of a cooling unit of the electronic device according to the eighteenth exemplary embodiment.

As shown in Fig. 62B, each hot-air passage body 14 includes base unit 23 and cover part 18, both of which extend to connect upper and lower vents 12 and 13. Base unit 23 is disposed on the side close to partition board 9, and cover part 18 is disposed on another side far from partition board 9 so as to cover base unit 23 from the side far from partition board 9. Base unit 23 is made larger in wall thickness than cover part 18. As shown in Fig. 63, hot-air passage bodies 14 are hollow bodies (air passages 52) formed by engaging cover parts 18 with base units 23 from outside.

Hot-air passage bodies 14 are resin-molded, and base units 23 are made larger in wall thickness than cover parts 18.

As shown in Fig. 63, in each heat exchanger, hot-air passage bodies 14 include division parts 19, lower collecting duct 14a, and lane part 21. Division parts 19 are formed by dividing upper vent 12 into a plurality of air passages 52. Lower collecting duct 14a combines all air passages 52 into one at lower vent 13. Lane part 21 connects division parts 19 and lower collecting duct 14a.

Lane part 21 is made thinner than division parts 19 and lower collecting duct 14a of hot-air passage bodies 14.

As shown in Fig. 62A, lane part 21 consists of a plurality of lane bodies 22 arranged horizontally side by side.

Thus, hot-air passage bodies 14 include lane part 21 consisting of a plurality of lane bodies 22. Each partition board 9 includes upper and lower vents 12 and 13. Upper vent 12 is a rectangle whose long side is in the direction in which lane bodies 22 are arranged. Lower vent 13 is a rectangle whose long and short sides have a smaller difference than those of upper vent 12.

In each heat exchanger, blower 11 is disposed at the bottom of display device 1, more specifically, at lower collecting duct 14a of hot-air passage bodies 14 in such a manner as to be opposed to lower vent 13. Blower 11 draws in air from upper vent 12, and blows the air into hot-air passage bodies 14 through lower vent 13.

A thin axial fan as blower 11 may be disposed at upper vent 12 in each cooling unit 7.

With this structure, when display device 1 is driven to turn on display unit 4, display unit 4 with plasma backlight and circuit components in control units 6 produce high heat.

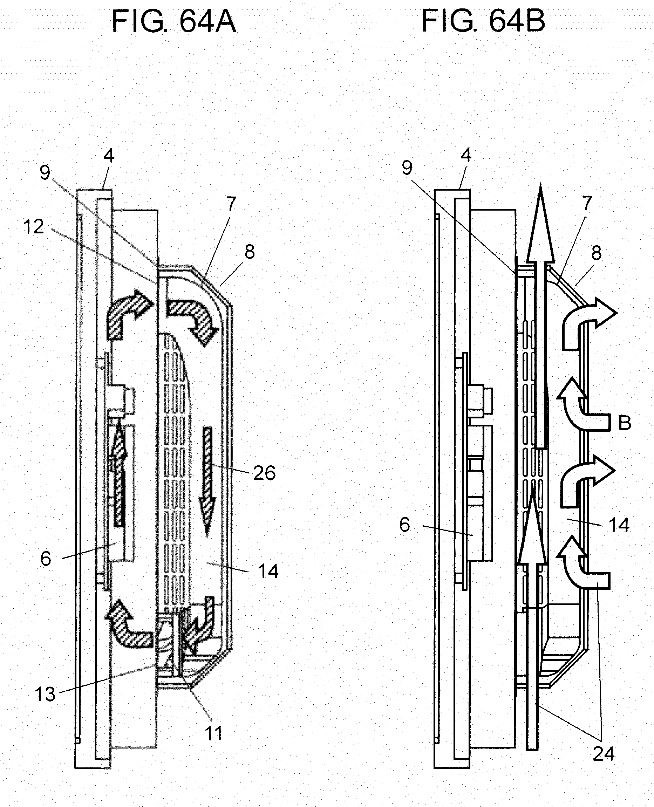

Fig. 64A is a sectional side view of the electronic device according to the eighteenth exemplary embodiment and air passages in the electronic device. Fig. 64B is a sectional side view showing air passages outside the heat exchanger of a cooling unit of the electronic device.

When display unit 4 is turned on, blowers 11 are started as shown in Fig. 64A. The air in the upper region of display device 1 is drawn into hot-air passage bodies 14 through division parts 19 of upper vents 12. The air in the lower region of display device 1 is collected at lower collecting duct 14a, and is again blown into display device 1 through lower vents 13. Thus, the air in display device 1 flows through third air passageways 26.

The air blown into display device 1 passes through the back side of display unit 4 and control units 6, and is again blown into hot-air passage bodies 14 through upper vents 12.

On the outside of hot-air passage bodies 14, that is, on the back surface of display device 1, rear covers 8 have a mesh or grid pattern as shown in Fig. 64B. This creates a chimney effect, generating natural convection and allowing the air to flow upward through first air passageways 24.

Then, the heat inside display device 1 is radiated to the outside via the resin boards composing hot-air passage bodies 14.

As described hereinbefore, in the present eighteenth exemplary embodiment, the heat that is generated by display unit 4 and control units 6 and is then trapped in display device 1 is exhausted by cooling units 7 to the outside of display device 1, thereby being effectively cooled by the outside air.

The air in the upper region of display device 1 is drawn through division parts 19 having a large width, and its heat is sufficiently radiated to the outside through lane parts 21 of hot-air passage bodies 14. The air is blown strongly into display device 1 through lower collecting ducts 14a by blowers 11 disposed at lower collecting ducts 14a Thus, the air inside display device 1 is fully circulated, thereby improving the high heat radiation effect created by cooling units 7.

Hot-air passage bodies 14, which are made of synthetic resin, are disposed only outside partition boards 9 formed on the back surface of display device 1, thereby preventing an increase in the weight of the electronic device.

Hot-air passage bodies 14 are made of synthetic resin, and each consists of base unit 23 and cover part 18.

The combination of base units 23 and cover parts 18 is important because the high-temperature air generated in display device 1 circulates through the electronic device as descried above.

In the present eighteenth exemplary embodiment, base units 23 are made larger in wall thickness than cover parts 18. This is because, when subjected to thermal expansion, thin-walled cover part 18 and thick-walled base unit 23 which covers thin-walled cover part 18 expand at different rates, thereby being firmly engaged with each other. Thick resin thermally expands more than thin resin. Therefore, when high-temperature air flows through hot-air passage bodies 14, base units 23 on the inside expand more than cover parts 18 on the outside, thereby being firmly engaged with each other.

In each heat exchanger, lane part 21, which has a long and narrow shape in the vertical direction of hot-air passage bodies 14, is made thinner than division parts 19 and lower collecting duct 14a. This prevents distortion due to thermal expansion, and makes lane part 21 elastic enough to absorb the stress caused by division parts 19 connected to partition board 9 and lower collecting duct 14a. Thus, hot-air passage bodies 14 can be maintained in a sealed condition for a long time, thereby providing reliable cooling unit 7.

### INDUSTRIAL APPLICABILITY

The present invention can reduce the airflow resistance inside the body without greatly decreasing the heat exchange efficiency. Therefore, the invention is applicable, for example, to blowers including heat exchange devices which are required to have low airflow resistance without increasing their size.

### REFERENCE MARKS IN THE DRAWINGS

- 1, 101, 201: display device
- 2: shop
- 3: under the eaves
- 4, 102, 203: display unit
- 5, 135, 204: body case
- 6, 107: control unit
- 7, 116, 207: cooling unit
- 8, 103: rear cover
- 9, 109, 208: partition board
- 10, 111, 209: heat exchanger
- 11, 110, 212: blower
- 12, 113: upper vent
- 13, 114: lower vent
- 14, 140: hot-air passage body
- 14a: lower collecting duct
- 15: air pathway
- 16, 142: convection path
- 17: airflow groove
- 18: cover part
- 19: division part
- 21: lane part
- 22: lane body
- 23: base unit
- 24: first air passageway
- 25: second air passageway
- 26: third air passageway
- 50: inner side
- 51: outer side
- 52: air passage
- 53: one surface
- 54: connection surface
- 55: hot part
- 104: first opening
- 105: second opening
- 106: third opening
- 108: cover
- 110a: fan
- 112: frame body
- 115, 127: peaks and valleys
- 115a, 115c, 127a: peak
- 115b, 127b: valley
- 115d, 127d: tunnel part
- 117: valley-forming part
- 117a: projection
- 118, 161, 162: attachment plate
- 121: convection passage
- 121a: micro convection
- 122, 122a: radiation air passage
- 123: swollen band
- 124: thermal conductive member
- 125: heating part
- 126: heatsink
- 128: main part
- 129: end face part
- 141: guide member
- 143, 214: air passageway
- 144: rectifier guide
- 145, 145a, 145b, 145c: first air passage
- 146, 146a, 146b: second air passage
- 147, 147a, 147b, 147c, 147d: third air passage
- 148: inlet port
- 149: outlet port
- 150: connection column
- 151: radiation frame
- 152: base plate
- 153: radiation board member
- 154: vent hole
- 155, 155a, 155b, 155c: shield wall
- 156: fin
- 157: guide
- 158: upper air-passage body
- 158a: lower-end insertion part
- 159: lower air-passage body
- 159a: upper-end insertion part
- 160: intermediate air-passage body
- 160a: intermediate-air-passage-body upper end
- 160b: intermediate-air-passage-body lower end
- 205: radiation board
- 206: high-temperature heating member
- 210: blower air inlet
- 211: blower air outlet
- 213: first space
- 215: circulating air inlet
- 216: circulating air outlet
- 217: partition part
- 218: rectifier air passage
- 219: rectifier-air-passage inlet
- 220: rectifier-air-passage outlet
- 222: first rectifier plate
- 223: second rectifier plate
- 224: circulating air temperature measuring means

## Claims

1. A cooling unit for electronic devices, comprising:
a partition board disposed on one of a plurality of surfaces of an electronic device, the partition board separating an inner side and an outer side of the electronic device;
a heat exchanger disposed on the outer side, the heat exchanger exchanging heat generated by the electronic device with outside air; and
a blower disposed on the outer side, wherein
the partition board has a first vent and a second vent,
the heat exchanger includes hot-air passage bodies and air pathways, the hot-air passage bodies including a plurality of air passages arranged side by side at predetermined intervals in such a manner as to connect the first vent and the second vent on the outer side, the air pathways being formed between adjacent ones of the air passages so as to allow the outside air to pass through, and
the blower blows air of the inner side from the first vent to the second vent through the hot-air passage bodies.

2. The cooling unit of claim 1, wherein
the blower is disposed at the second vent.

3. The cooling unit of claim 1, wherein
the partition board is one of a plurality of partition boards disposed on the one surface.

4. The cooling unit of claim 1, wherein
the air passages are connected to the second vent via a lower collecting duct, and the blower is disposed in the lower collecting duct.

5. The cooling unit of claim 1, wherein
the partition board has a rectangular shape,
the first vent is formed in an upper region of the partition board, and
the second vent is formed in a lower region of the partition board.

6. The cooling unit of claim 1, wherein
the hot-air passage bodies extend like bridges.

7. The cooling unit of claim 6, wherein
the hot-air passage bodies include convection paths between the partition board and the air passages, the convection paths extending between a bottom of the first vent and a top of the second vent.

8. An electronic device comprising:
a body case having a front side and a back side, the body case including a display unit on the front side;
a control unit disposed in the body case on the back side of the display unit; and
the cooling unit of claim 1 disposed on the back side, the cooling unit radiating heat generated by the control unit and the display unit.

9. The electronic device of claim 8, wherein
the cooling unit is one of a plurality of the cooling units.

10. The electronic device of claim 9, wherein
the plurality of cooling units each have an outer surface covered with a rear cover allowing outside air to pass through.

11. The electronic device of claim 8, wherein
the control unit includes a hot part in a vicinity of the second vent.

12. The electronic device of claim 8, wherein
the body case has a horizontally long rectangular shape, which is longer in a horizontal direction than in a vertical direction;
the first vent is formed in a position corresponding to an upper region of the body case; and
the second vent is formed in a position corresponding to a lower region of the body case.

13. The electronic device of claim 8, wherein
the body case has a vertically long rectangular shape, which is longer in a vertical direction than in a horizontal direction;
the first vent is formed in a position corresponding to one of left and right sides of the body case; and
the second vent is formed in a position corresponding to the other one of the left and right sides of the body case.

14. The cooling unit of claim 4, wherein
the air pathways decrease in length with distance from the center of the connection surface.

15. The cooling unit of claim 4, wherein
the lower collecting duct is provided with airflow grooves communicated with the air pathways.

16. The cooling unit of claim 7, wherein
the convection paths include a plurality of rectifier guides arranged at predetermined intervals and at right angles to the hot-air passage bodies.

17. The cooling unit of claim 1, wherein
the hot-air passage bodies each include:
an upper air-passage body connected to the first vent;
a lower air-passage body connected to the second vent; and
an intermediate air-passage body connecting the upper air-passage body and the lower air-passage body.

18. The cooling unit of claim 1, wherein
the hot-air passage bodies each include:
a base unit disposed on a side close to the partition board, the base unit connecting the first vent and the second vent; and
a cover part disposed on another side far from the partition board, the cover part covering the base unit from the side far from the partition board, and connecting the first vent and the second vent, wherein
the base unit is made larger in wall thickness than the cover part.
